(19) Europäisches Patentamt
European Patent Office
Office européen des brevets

(11) **EP 4 561 303 B1**

(12) **EUROPEAN PATENT SPECIFICATION**

(45) Date of publication and mention
of the grant of the patent:
**15.04.2026 Bulletin 2026/16**

(21) Application number: **24206908.6**

(22) Date of filing: **16.10.2024**

(51) International Patent Classification (IPC):
***H10F 39/18*** *(2025.01)*

(52) Cooperative Patent Classification (CPC):
**H10F 39/8063; H10F 39/182; H10F 39/802**

(54) **IMAGE SENSOR HAVING NANO-PHOTONIC LENS ARRAY AND ELECTRONIC APPARATUS INCLUDING THE IMAGE SENSOR**

BILDSENSOR MIT NANOPHOTONISCHER LINSENANORDNUNG UND ELEKTRONISCHE VORRICHTUNG MIT DEM BILDSENSOR

CAPTEUR D'IMAGE AYANT UN RÉSEAU DE LENTILLES NANOPHOTONIQUES ET APPAREIL ÉLECTRONIQUE COMPRENANT LE CAPTEUR D'IMAGE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **27.11.2023 KR 20230167156**
**11.10.2024 KR 20240138424**

(43) Date of publication of application:
**28.05.2025 Bulletin 2025/22**

(73) Proprietor: **Samsung Electronics Co., Ltd.**
**Suwon-si, Gyeonggi-do 16677 (KR)**

(72) Inventors:
• **LEE, Sangyun**
**16678 Suwon-si (KR)**
• **PARK, Hyunsung**
**16678 Suwon-si (KR)**
• **ROH, Sookyoung**
**16678 Suwon-si (KR)**
• **CHO, Choonlae**
**16678 Suwon-si (KR)**

(74) Representative: **Elkington and Fife LLP**
**Prospect House**
**8 Pembroke Road**
**Sevenoaks, Kent TN13 1XR (GB)**

(56) References cited:
**US-A1- 2023 020 980    US-A1- 2023 115 006**

**Description**

FIELD OF THE INVENTION

One or more embodiments relate to an image sensor including a nano-photonic lens array and an electronic apparatus including the image sensor.

BACKGROUND OF THE INVENTION

Image sensors generally sense the color of incident light by using a color filter. However, a color filter may have a relatively low light utilization efficiency because the color filter absorbs light of colors other than the intended color of light. For example, in the case in which a red-green-blue (RGB) color filter is used, only 1/3 of the incident light is transmitted therethrough and the other part of the incident light, that is, 2/3 of the incident light, is absorbed. Thus, the light utilization efficiency is only about 33%. Thus, in a color display apparatus or a color image sensor, most light loss occurs in the color filter. Documents US 2023020980 A1 and US2023115006 (A1) show an image sensor comprising a nano-photonic lens array according to the prior-art.

SUMMARY OF THE INVENTION

One or more embodiments provide an image sensor including a nano-photonic lens array and having an improved optical efficiency, and an electronic apparatus including the image sensor.

Additional aspects will be set forth in part in the description which follows and, in part, will be apparent from the description, or may be learned by practice of the presented embodiments of the disclosure.

According to an aspect of an example embodiment, there is provided an image sensor including a sensor substrate including a first pixel, a second pixel, a third pixel, and a fourth pixel, the first pixel, the second pixel, the third pixel, and the fourth pixel being configured to sense light, and a nano-photonic lens array including a first meta-region, a second meta-region, a third meta-region, and a fourth meta-region, the first meta-region corresponding to the first pixel, the second meta-region corresponding to the second pixel, the third meta-region corresponding to the third pixel, and the fourth meta-region corresponding to the fourth pixel, wherein each of the first meta-region, the second meta-region, the third meta-region, and the fourth meta-region include a plurality of nano-structures configured to color-separate incident light that is incident on the nano-photonic lens array and condense light of a first wavelength band onto the first pixel and the fourth pixel, light of a second wavelength band onto the second pixel, and light of a third wavelength band onto the third pixel, wherein the first meta-region includes a plurality of pairs of two nano-structures that are symmetrical in a first direction at different distances in a second direction that is perpendicular to the first direction from a horizontal center line, the horizontal center line passing through a center of the first meta-region along the first direction, and wherein, in a direction toward the horizontal center line in the second direction, an interval between two symmetrical nano-structures among the plurality of pairs of two nano-structures in the first direction increases, and in a direction away from the horizontal center line in the second direction, an interval between two symmetrical nano-structures among the plurality of pairs of two nano-structures in the first direction decreases.

An interval in the first direction between two nano-structures among the plurality of pairs of two nano-structures that are symmetrical on the horizontal center line in the first direction may be L/8 to 3L/8, where L is a length of a side of the first meta-region.

An interval $\Delta S$ in the first direction between two symmetrical nano-structures that are arranged at a distance d from the horizontal center line in the second direction may satisfy $2L(0.13-0.47y^2)<\Delta S<2L(0.38-0.96y^2-0.89y^4-1.63y^6)$, where y=d/L and $0 < y < 0.5$.

The first meta-region may include a first nano-structure on a vertical center line that passes through the center of the first meta-region in the second direction, a second nano-structure and a third nano-structure that are symmetrical in the first direction at a first distance from the horizontal center line in the second direction, and a fourth nano-structure and a fifth nano-structure that are symmetrical in the first direction at a second distance from the horizontal center line in the second direction, the second distance being less than the first distance, wherein an interval between the fourth nano-structure and the fifth nano-structure in the first direction is greater than an interval between the second nano-structure and the third nano-structure in the first direction.

The second nano-structure and the third nano-structure may be symmetrical to each other in the first direction with respect to the vertical center line, and the fourth nano-structure and the fifth nano-structure may be symmetrical to each other in the first direction with respect to the vertical center line.

An interval in the first direction between the fourth nano-structure and the fifth nano-structure or an interval in the first direction between the second nano-structure and the third nano-structure, which are at a distance d from the horizontal center line in the second direction, is $\Delta S$, and $\Delta S$ may satisfy $2L(0.13-0.47y^2)<\Delta S<2L(0.38-0.96y^2-0.89y^4-1.63y^6)$, where

L denotes a length of one side of the first meta-region, and y=d/L and 0 < y < 0.5.

The first nano-structure may have a first cross-sectional size, the second nano-structure and the third nano-structure may have a second cross-sectional size, and the fourth nano-structure and the fifth nano-structure may have a third cross-sectional size, and an average of the second cross-sectional size and the third cross-sectional size may be greater than the first cross-sectional size.

A ratio of the first cross-sectional size with respect to the average of the second cross-sectional size and the third cross-sectional size may be less than or equal to 0.85.

A ratio of the first cross-sectional size with respect to the average of the second cross-sectional size and the third cross-sectional size may be 0.7 to 0.8.

The first meta-region may include a sixth nano-structure and a seventh nano-structure that are symmetrical in the first direction at the first distance from the horizontal center line in the second direction, and an eighth nano-structure and a ninth nano-structure that are symmetrical in the first direction at the second distance from the horizontal center line in the second direction, wherein an interval between the second nano-structure and the third nano-structure in the first direction is greater than an interval between the sixth nano-structure and the seventh nano-structure in the first direction, and an interval between the fourth nano-structure and the fifth nano-structure in the first direction is greater than an interval between the eighth nano-structure and the ninth nano-structure in the first direction.

The fourth nano-structure may be on a first diagonal line passing through the center of the first meta-region, and the fifth nano-structure may be on a second diagonal line that crosses the first diagonal line and passes through the center of the first meta-region.

The first meta-region further may inlcude a plurality of nano-structures that are respectively symmetrical to the second nano-structure and the third nano-structure with respect to the first diagonal line, and a plurality of nano-structures that are respectively symmetrical to the second nano-structure and the third nano-structure with respect to the second diagonal line.

The first nano-structure, the second nano-structure, the third nano-structure, the fourth nano-structure, and the fifth nano-structure may have a cross-sectional size of greater than 80 nm, and the plurality of nano-structures that are respectively symmetrical to the second nano-structure and the third nano-structure with respect to the first diagonal line and the plurality of nano-structures that are respectively symmetrical to the second nano-structure and the third nano-structure with respect to the second diagonal line each may have a cross-sectional size less than or equal to 80 nm.

The first meta-region further may include a plurality of nano-structures that are symmetrical to the first nano-structure, the second nano-structure, the third nano-structure, the fourth nano-structure, and the fifth nano-structure in the second direction with respect to the horizontal center line.

The first meta-region may include a first-1 nano-structure and a first-2 nano-structure that are symmetrical in the first direction, a second nano-structure and a third nano-structure that are symmetrical in the first direction at a first distance from the horizontal center line in the second direction, and a fourth nano-structure and a fifth nano-structure that are symmetrical in the first direction at a second distance from the horizontal center line in the second direction, the second distance being less than the first distance, wherein an interval between the fourth nano-structure and the fifth nano-structure in the first direction is greater than an interval between the second nano-structure and the third nano-structure in the first direction, and an interval between the first-1 nano-structure and the first-2 nano-structure in the first direction is less than an interval between the second nano-structure and the third nano-structure in the first direction.

An average cross-sectional size of the first-1 nano-structure and the first-2 nano-structure may be less than an average cross-sectional size of the second nano-structure, the third nano-structure, the fourth nano-structure, and the fifth nano-structure.

A ratio of an average cross-sectional size of the first-1 nano-structure and the first-2 nano-structure with respect to an average cross-sectional size of the second to fifth nano-structures may be less than or equal to 0.85.

The first-1 nano-structure and the first-2 nano-structure may be between a pair of the second nano-structure and the third nano-structure and a pair of the fourth nano-structure and the fifth nano-structure in the second direction from the horizontal center line.

The first meta-region and the fourth meta-region may be arranged in a first diagonal direction, and the second meta-region and the third meta-region may be arranged in a second diagonal direction that crosses the first diagonal direction, and the fourth meta-region may be rotated by a 90-degree angle with respect to the first meta-region.

According to another aspect of an example embodiment, there is provided an electronic apparatus including a lens assembly configured to form an optical image of a subject, an image sensor configured to convert the optical image formed by the lens assembly into an electrical signal, and a processor configured to process the electrical signal generated by the image sensor including a sensor substrate including a first pixel, a second pixel, a third pixel, and a fourth pixel, the first pixel, the second pixel, the third pixel, and the fourth pixel being configured to sense light, and a nano-photonic lens array including a first meta-region, a second meta-region, a third meta-region, and a fourth meta-region, the first meta-region corresponding to the first pixel, the second meta-region corresponding to the second pixel, the third meta-region corresponding to the third pixel, and the fourth meta-region corresponding to the fourth pixel, wherein each of the first meta-region, the second meta-region, the third meta-region, and the fourth meta-region include a plurality of nano-structures configured to color-separate incident light that is incident on the nano-photonic lens array and condense light of a first wavelength band onto the first pixel and the fourth pixel, light of a second wavelength band onto the second pixel, and light of a third wavelength band onto the third pixel, wherein the first meta-region includes a plurality of pairs of two nano-structures that are symmetrical in a first direction at different distances in a second direction that is perpendicular to the first direction from a horizontal center line, the horizontal center line passing through a center of the first meta-region along the first direction, and wherein, in a direction toward the horizontal center line in the second direction, an interval between two symmetrical nano-structures among the plurality of pairs of two nano-structures in the first direction increases, and in a direction away from the horizontal center line in the second direction, an interval between two symmetrical nano-structures among the plurality of pairs of two nano-structures in the first direction decreases.

BRIEF DESCRIPTION OF DRAWINGS

The above and other aspects, features, and advantages of example embodiments of the disclosure will be more apparent from the following description taken in conjunction with the accompanying drawings, in which:

FIG. 1 is a schematic block diagram of an image sensor according to an example embodiment;
FIGS. 2A, 2B, and 2C are diagrams showing examples of various pixel arrangements in a pixel array of an image sensor;
FIGS. 3A and 3B are cross-sectional views schematically showing a structure of a pixel array in an image sensor according to an embodiment;
FIG. 4A is a plan view schematically showing a pixel arrangement of a sensor substrate in the pixel array of FIGS. 3A and 3B;
FIG. 4B is a plan view schematically showing another pixel arrangement of a sensor substrate in the pixel array of FIGS. 3A and 3B;
FIG. 5 is a plan view schematically showing a structure of a color filter layer in the pixel array of FIGS. 3A and 3B;
FIG. 6 is a plan view showing an example of a unit meta-pattern in a nano-photonic lens array of FIGS. 3A and 3B;
FIG. 7 is a diagram showing an example of phase profiles of green light and blue light after passing through a nano-photonic lens array;
FIG. 8 is a diagram showing an example of phase profiles of red light and green light after passing through a nano-photonic lens array;
FIG. 9 is a diagram showing an example of an array of a green light condensing region formed by a nano-photonic lens array;
FIG. 10 is a diagram showing an example of an array of a blue light condensing region formed by a nano-photonic lens array;
FIG. 11 is a diagram showing an example of an array of a red light condensing region formed by a nano-photonic lens array;
FIG. 12 is a graph showing an example of a relationship between various geometrical shapes of a plurality of nano-structures of a nano-photonic lens array and a difference in autofocusing (AF) characteristics of a first pixel and a fourth pixel in one unit pixel pattern;
FIG. 13 is a graph showing an example of a relationship between various geometrical shapes of a plurality of nano-structures of a nano-photonic lens array and a difference in modulation transfer function (MTF) characteristics of a first pixel and a fourth pixel in one unit pixel pattern;
FIG. 14 is a plan view showing a structure of a nano-photonic lens array according to a related example;
FIG. 15 is a diagram showing an example of a light spot shape of green light formed on a first pixel by the nano-photonic lens array according to the related example;
FIG. 16 is a diagram showing an example of a light spot shape of green light formed on a first pixel by a nano-photonic lens array according to an example embodiment;
FIG. 17 is a plan view showing another example of a first meta-region in a nano-photonic lens array;
FIG. 18 is a plan view showing another example of a first meta-region in a nano-photonic lens array;
FIG. 19 is a plan view showing another example of a first meta-region in a nano-photonic lens array;
FIG. 20 is a plan view showing another example of one unit meta-pattern in a nano-photonic lens array;
FIG. 21 is a plan view showing another example of one unit meta-pattern in a nano-photonic lens array;
FIG. 22 is a block diagram of an electronic apparatus including an image sensor according to an example embodiment;
FIG. 23 is a block diagram of a camera module in FIG. 22;
FIG. 24 is a block diagram of an electronic device including a multi-camera module; and
FIG. 25 is a detailed block diagram of a multi-camera module in the electronic device of FIG. 24.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects. As used herein, the term "and/or" includes any and all combinations of one or more of the associated listed items. Expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

Hereinafter, an image sensor including a nano-photonic lens array and an electronic apparatus including the image sensor will be described in detail with reference to accompanying drawings. The embodiments of the disclosure are capable of various modifications and may be embodied in many different forms. In the drawings, like reference numerals denote like components, and sizes of components in the drawings may be exaggerated for convenience of explanation.

When a layer, a film, a region, or a panel is referred to as being "on" another element, it may be directly on/under/at left/right sides of the other layer or substrate, or intervening layers may also be present.

It will be understood that although the terms "first," "second," etc. may be used herein to describe various components, these components should not be limited by these terms. These components are only used to distinguish one component from another. These terms do not limit that materials or structures of components are different from one another.

An expression used in the singular encompasses the expression of the plural, unless it has a clearly different meaning in the context. It will be further understood that when a portion is referred to as "comprising" another component, the portion may not exclude another component but may further comprise another component unless the context states otherwise.

In addition, the terms such as "... unit", "module", etc. provided herein indicates a unit performing a function or operation, and may be realized by hardware, software, or a combination of hardware and software.

The use of the terms of "the above-described" and similar indicative terms may correspond to both the singular forms and the plural forms.

Also, the steps of all methods described herein may be performed in any suitable order unless otherwise indicated herein or otherwise clearly contradicted by context. Also, the use of all exemplary terms (for example, etc.) is only to describe a technical detail, and the scope of rights is not limited by these terms unless the context is limited by the claims.

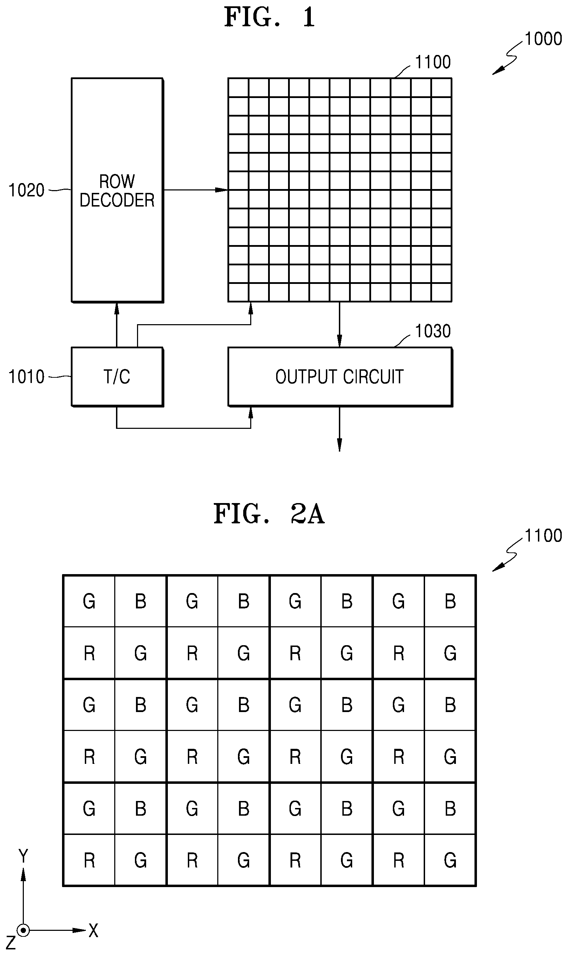

FIG. 1 is a schematic block diagram of an image sensor 1000 according to an example embodiment. Referring to FIG. 1, the image sensor 1000 may include a pixel array 1100, a timing controller (T/C) 1010, a row decoder 1020, and an output circuit 1030. The image sensor 1000 may be a charge-coupled device (CCD) image sensor or a complementary metal oxide semiconductor (CMOS) image sensor.

The pixel array 1100 includes pixels that are two-dimensionally disposed in a plurality of rows and columns. The row decoder 1020 selects one of the rows in the pixel array 1100 in response to a row address signal output from the timing controller 1010. The output circuit 1030 outputs a photosensitive signal, in a line unit, from a plurality of pixels disposed in the selected row. To this end, the output circuit 1030 may include a column decoder and an analog-to-digital converter (ADC). For example, the output circuit 1030 may include a plurality of ADCs that are disposed respectively to columns between the column decoder and the pixel array 1100, or one ADC disposed at an output end of the column decoder. The timing controller 1010, the row decoder 1020, and the output circuit 1030 may be implemented as one chip or in separate chips. A processor for processing an image signal output from the output circuit 1030 may be implemented as one chip with the timing controller 1010, the row decoder 1020, and the output circuit 1030.

The pixel array 1100 may include a plurality of pixels that sense light of different wavelengths. The pixel arrangement may be implemented in various ways. For example, FIGS. 2A to 2C show various pixel arrangements in the pixel array 1100 of the image sensor 1000.

FIG. 2A shows an arrangement of Bayer pattern that may be used in the image sensor 1000. Referring to FIG. 2A, one unit pixel pattern includes four quadrant regions, and first through fourth quadrants may be the blue pixel B, the green pixel G, the red pixel R, and the green pixel G, respectively. The unit pixel patterns are repeatedly two-dimensionally arranged in a first direction (an X direction) and a second direction (a Y direction) perpendicular to the first direction. In other words, two green pixels G are disposed in one diagonal direction and one blue pixel B and one red pixel R are disposed in another diagonal direction in a unit pixel pattern of a 2×2 array. In the entire arrangement of pixels, a first row in which a plurality of green pixels G and a plurality of blue pixels B are alternately disposed in the first direction and a second row in which a plurality of red pixels R and a plurality of green pixels G are alternately disposed in the first direction are repeatedly disposed in a second direction.

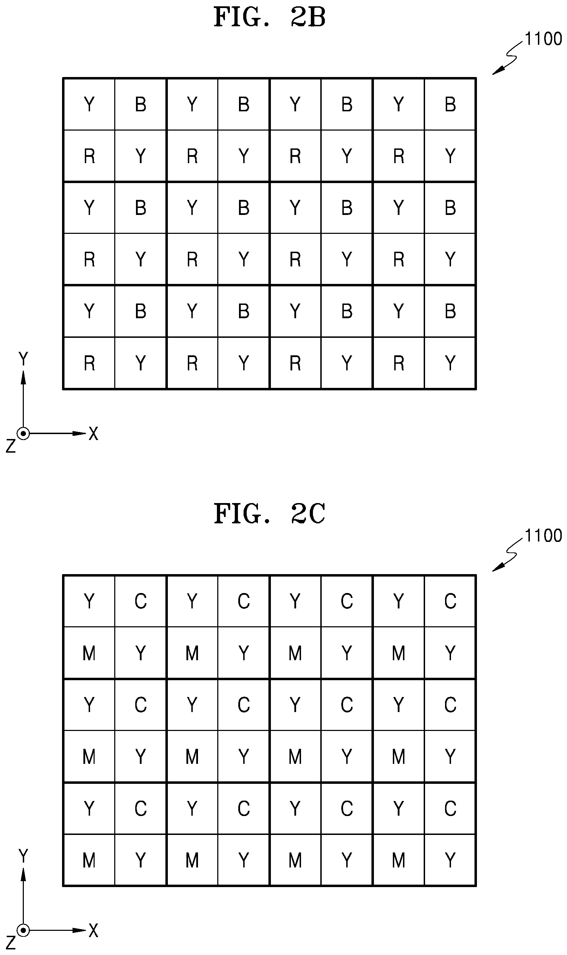

The pixel array 1100 may have various arrangement patterns, rather than the Bayer pattern. For example, referring to FIG. 2B, a red-yellow-blue (RYB) arrangement in which a yellow pixel Y is used instead of a green pixel G in the Bayer pattern may be used. Also, referring to FIG. 2C, a cyan-magenta-yellow (CMY) arrangement in which a cyan pixel C, a magenta pixel M, and two yellow pixels Y form one unit pixel pattern may be used. In the arrangements shown in FIGS. 2A to 2C, the number of certain color channels may be twice greater than those of the other color channels in one unit pixel pattern. For example, in the RGB Bayer pattern shown in FIG. 2A, green channels are twice more than red channels or blue channels. In the RYB arrangement shown in FIG. 2B, yellow channels may be twice more than the red channels or blue channels. In the CMY arrangement shown in FIG. 2C, yellow channels are twice more than cyan channels or magenta channels.

Hereinafter, an example in which the pixel array 1100 of the image sensor 1000 has the Bayer pattern structure shown in FIG. 2A is described, but operating principles may be identically applied to other types of pixel arrangements shown in FIG. 2B or 2C.

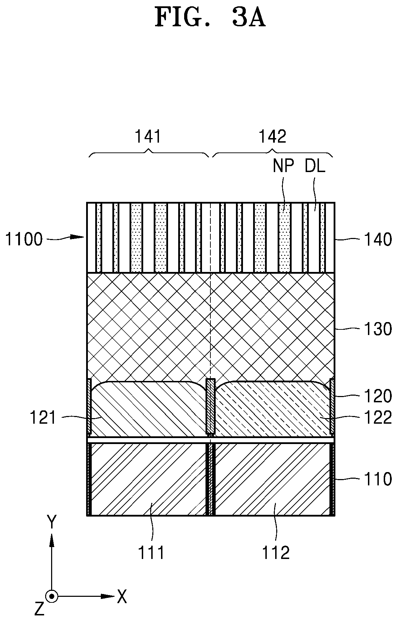

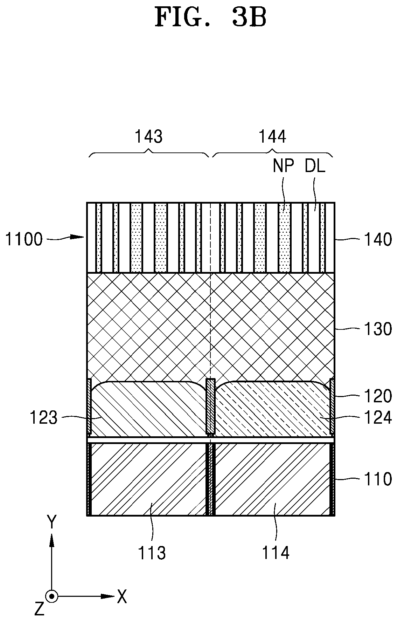

FIGS. 3A and 3B are cross-sectional views schematically showing a structure of the pixel array 1100 in the image sensor 1000 according to an example embodiment. FIG. 3A shows a cross-section of the pixel array 1100 taken along the first direction (X-direction), and FIG. 3B shows a cross-section of the pixel array 1100, taken along the first direction (X-direction) at a location different from that of FIG. 3A in the second direction (Y-direction).

Referring to FIGS. 3A and 3B, the pixel array 1100 may include a sensor substrate 110, a color filter layer 120 disposed on the sensor substrate 110, a planarization layer 130 that is transparent and disposed on the color filter layer 120, and a nano-photonic lens array 140 disposed on the planarization layer 130.

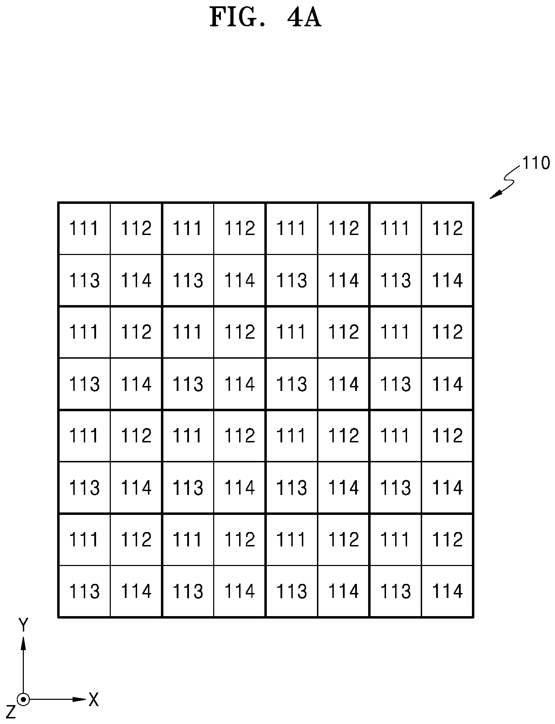

FIG. 4A is a plan view schematically showing pixel arrangement of a sensor substrate 110 in the pixel array 1100 of FIGS. 3A and 3B. Referring to FIG. 4A, the sensor substrate 110 may include a plurality of pixels sensing incident light. For example, the sensor substrate 110 may include a first pixel 111, a second pixel 112, a third pixel 113, and a fourth pixel 114 that convert incident light into electrical signals and generate an image signal. The first pixel 111, the second pixel 112, the third pixel 113, and the fourth pixel 114 may form one unit pixel pattern. In the sensor substrate 110, a plurality of unit pixel patterns each including the first pixel 111, the second pixel 112, the third pixel 113, and the fourth pixel 114 may be periodically repeated and two-dimensionally arranged in the first direction (X-direction) and the second direction (Y-direction). For example, a plurality of first pixels 111 and a plurality of second pixels 112 may be alternately disposed in the first direction, and a plurality of third pixels 113 and a plurality of fourth pixels 114 may be alternately disposed in the first direction on a cross-section located differently in the second direction that is perpendicular to the first direction. Also, the plurality of first pixels 111 and the plurality of fourth pixels 114 may be arranged in a first diagonal direction and the plurality of second pixels 112 and the plurality of third pixels 113 may be arranged in a second diagonal direction crossing the first diagonal direction.

In an example, the first and fourth pixels 111 and 114 may be green pixels sensing green light, the second pixel 112 may be a blue pixel sensing blue light, and the third pixel 113 may be a red pixel sensing red light. In another example, the first and fourth pixels 111 and 114 may be yellow pixels sensing yellow light, the second pixel 112 may be a blue pixel sensing blue light, and the third pixel 113 may be a red pixel sensing red light. In another example, the first and fourth pixels 111 and 114 may be yellow pixels sensing yellow light, the second pixel 112 may be a cyan pixel sensing cyan light, and the third pixel 113 may be a magenta pixel sensing magenta light. Therefore, the first pixel 111 and the fourth pixel 114 arranged in one unit pixel pattern may form the same color channels.

In an example, each of the first to fourth pixels 111, 112, 113, and 114 may include one photosensitive cell. For example, each of the first to fourth pixels 111, 112, 113, and 114 may include one photodiode.

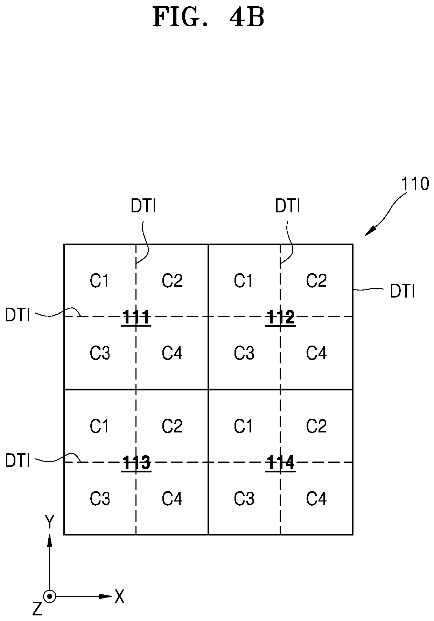

FIG. 4B is a plan view schematically showing another pixel arrangement of the sensor substrate 110 in the pixel array 1100 of FIGS. 3A and 3B. Referring to FIG. 4B, each of the first to fourth pixels 111, 112, 113, and 114 may include a plurality of photosensitive cells that independently sense the incident light. In this case, each of the first to fourth pixels 111, 112, 113, and 114 may include a plurality of photodiodes. For example, each of the first to fourth pixels 111, 112, 113, and 114 may include first to fourth photosensitive cells C1, C2, C3, and C4. The first to fourth photosensitive cells C1, C2, C3, and C4 may be two-dimensionally disposed in the first direction and the second direction. For example, in each of the first to fourth pixels 111, 112, 113, and 114, the first to fourth photosensitive cells C1, C2, C3, and C4 may be disposed in a 2x2 array.

FIG. 4B shows an example in which each of the first to fourth pixels 111, 112, 113, and 114 includes four photosensitive cells, but embodiments are not limited thereto, and for example, four or more independent photosensitive cells may be grouped and two-dimensionally arranged. For example, each of the first to fourth pixels 111, 112, 113, and 114 may include a plurality of independent photosensitive cells that are grouped and arranged in a 3x3 array or 4x4 array. Hereinafter, an example in which each of the first to fourth pixels 111, 112, 113, and 114 includes the photosensitive cells arranged in a 2x2 array will be described for convenience of description.

When each of the first to fourth pixels 111, 112, 113, and 114 includes a plurality of photosensitive cells, an autofocusing signal may be obtained from a difference between output signals from adjacent photosensitive cells. For example, an autofocusing signal in the first direction may be generated from a difference between output signals from the first photosensitive cell C1 and the second photosensitive cell C2, a difference between output signals from the third photosensitive cell C3 and the fourth photosensitive cell C4, or a difference between a sum of the output signals from the first photosensitive cell C1 and the third photosensitive cell C3 and a sum of the output signals from the second photosensitive cell C2 and the fourth photosensitive cell C4. Also, an autofocusing signal in the second direction may be generated from a difference between output signals from the first photosensitive cell C1 and the third photosensitive cell C3, a difference between output signals from the second photosensitive cell C2 and the fourth photosensitive cell C4, or a difference between a sum of the output signals from the first photosensitive cell C1 and the second photosensitive cell C2 and a sum of the output signals from the third photosensitive cell C3 and the fourth photosensitive cell C4.

A general image signal may be obtained from the sum of the output signals from the first to fourth photosensitive cells C1, C2, C3, and C4. For example, a first green image signal may be generated by summing the output signals from the first to fourth photosensitive cells C1, C2, C3, and C4 of the first pixel 111, a blue image signal may be generated by summing the output signals from the first to fourth photosensitive cells C1, C2, C3, and C4 of the second pixel 112, a red image signal may be generated by summing the output signals from the first to fourth photosensitive cells C1, C2, C3, and C4 of the third pixel 113, and a second green image signal may be generated by summing the output signals from the first to fourth photosensitive cells C1, C2, C3, and C4 of the fourth pixel 114.

Also, each of the first to fourth pixels 111, 112, 113, and 114 may include isolations DTI that electrically isolate the plurality of photosensitive cells from one another. The isolation DTI may have, for example, a deep trench isolation structure. The deep trench may be filled with, for example, air or an electrically insulating material. The isolations DTI may extend in the first direction and the second direction so as to divide each of the first to fourth pixels 111, 112, 113, and 114 into four cells. The first to fourth photosensitive cells C1, C2, C3, and C4 in each of the first to fourth pixels 111, 112, 113, and 114 may be isolated from one another by the isolations DTI. The isolation DTI extending in the first direction and the isolation DTI extending in the second direction may cross each other at the center of each of the first to fourth pixels 111, 112, 113, and 114.

Also, the isolations DTI may be disposed in the first direction and the second direction between adjacent pixels from among the first to fourth pixels 111, 112, 113, and 114. Therefore, the first to fourth pixels 111, 112, 113, and 114 may be isolated from one another due to the isolations DTI. The isolation DTI extending in the first direction and the isolation DTI extending in the second direction may cross each other at the center of the unit pixel pattern including the first to fourth pixels 111, 112, 113, and 114.

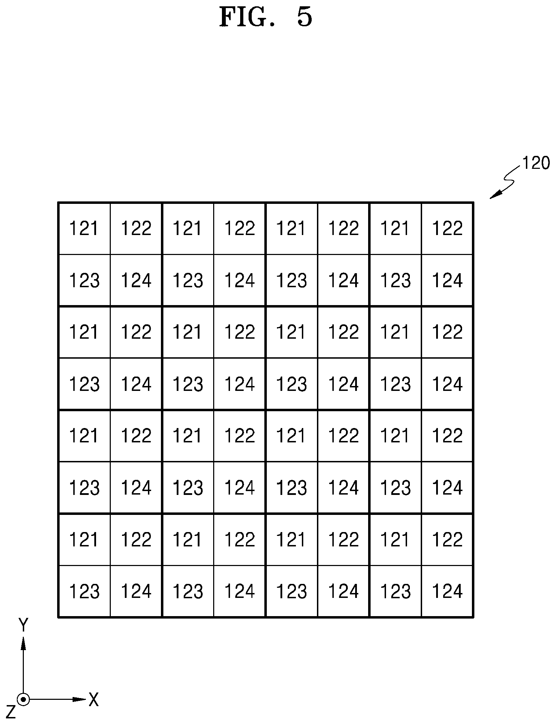

FIG. 5 is a plan view schematically showing a structure of the color filter layer 120 of FIGS. 3A and 3B. Referring to FIG. 5, the color filter layer 120 may include a plurality of color filters that are disposed between the sensor substrate 110 and the nano-photonic lens array 140 so as to transmit light of a certain wavelength band and absorb light of another wavelength band. For example, the color filter layer 120 may include a first color filter 121 and a fourth color filter 124 that transmit light of a first wavelength band and absorb light of another wavelength band, a second color filter 122 that transmits light of a second wavelength band that is different from the first wavelength band and absorbs light of another wavelength band, and a third color filter 123 that transmits light of a third wavelength band that is different from the first and second wavelength bands and absorbs light of another wavelength band.

The first color filter 121, the second color filter 122, the third color filter 123, and the fourth color filter 124 may form one unit color filter pattern. In the color filter layer 120, a plurality of unit color filter patterns each including the first color filter 121, the second color filter 122, the third color filter 123, and the fourth color filter 124 are regularly and repeatedly arranged in a two-dimensional array in the first direction (X-direction) and the second direction (Y-direction). For example, a plurality of first color filters 121 and a plurality of second color filter 122 may be alternately arranged in the first direction, and a plurality of third color filters 123 and a plurality of fourth color filters 124 may be alternately arranged in the first direction on a cross-section of a different position in the second direction that is perpendicular to the first direction. Also, a plurality of first color filters 121 and a plurality of fourth color filters 124 may be arranged in the first diagonal direction, and a plurality of second color filters 122 and a plurality of third color filters 123 may be arranged in the second diagonal direction crossing the first diagonal direction.

The first color filter 121 may be disposed to face the first pixel 111 in a third direction (that is, Z-axis direction) that is perpendicular to the first and second directions, the second color filter 122 may be disposed to face the second pixel 112 in the third direction, the third color filter 123 may be disposed to face the third pixel 113 in the third direction, and the fourth color filter 124 may be disposed to face the fourth pixel 114 in the third direction. Accordingly, the first pixel 111 may sense the light of the first wavelength band that passed through the first color filter 121 corresponding thereto. The second pixel 112 senses the light of the second wavelength band that passed through the corresponding second color filter 122, and the third pixel 113 senses the light of the third wavelength band that passed through the corresponding third color filter 123. The fourth pixel 114 may sense the light of the first wavelength band that has passed through the fourth color filter 124 corresponding thereto.

In an example, the first color filter 121 and the fourth color filter 124 may be green color filters transmitting the green light, the second color filter 122 may be a blue color filter transmitting the blue light, and the third color filter 123 may be a red color filter transmitting the red light. In another example, the first color filter 121 and the fourth color filter 124 may be yellow color filters transmitting yellow light, the second color filter 122 may be a blue color filter, and the third color filter 123 may be a red color filter. In another example, the first color filter 121 and the fourth color filter 124 may be yellow color filters, the second color filter 122 may be a cyan color filter transmitting cyan light, and the third color filter 123 may be a magenta color filter transmitting magenta light.

When each of the first to fourth pixels 111, 112, 113, and 114 includes a plurality of photosensitive cells, the first to fourth color filters 121, 122, 123, and 124 may be arranged to face all of the photosensitive cells in the corresponding first to fourth pixels 111, 112, 113, and 114 in the third direction. For example, the first color filter 121 faces and covers all photosensitive cells in the first pixel 111, the second color filter 122 faces and covers all photosensitive cells in the second pixel 112, the third color filter 123 faces and covers all photosensitive cells in the third pixel 113, and the fourth color filter 124 faces and covers all photosensitive cells in the fourth pixel 114.

The first to fourth color filters 121, 122, 123, and 124 in the color filter layer 120 may be formed of, for example, an organic polymer material. For example, the first to fourth color filters 121, 122, 123, and 124 may include a coloring agent, binder resin, polymer photoresist, etc. For example, the first and fourth color filters 121 and 124 may be organic color filters including green organic dye or a green organic pigment as a coloring agent, the second color filter 122 may be an organic color filter including a blue organic dye or a blue organic pigment as a coloring agent, and the third color filter 123 may be an organic color filter including a red organic dye or a red organic pigment as a coloring agent. According to example embodiments, the color filter layer 120 may further include a black matrix disposed at boundaries between the first to fourth color filters 121, 122, 123, and 124. The black matrix may include, for example, carbon black.

Referring back to FIGS. 3A and 3B, the planarization layer 130 arranged between the color filter layer 120 and the nano-photonic lens array 140 may provide a flat surface for forming the nano-photonic lens array 140 on the planarization layer 130. The planarization layer 130 may include an organic polymer material that is suitable for being stacked on the color filter layer 120 that is formed of an organic material and may more easily form a flat surface. The organic polymer material forming the planarization layer 130 may be transparent with respect to visible light. For example, the planarization layer 130 may include at least one organic polymer material from an epoxy resin, polyimide, polycarbonate, polyacrylate, and polymethyl methacrylate (PMMA). The planarization layer 130 may be formed on the color filter layer 120 by, for example, a spin coating method, and may have a flat upper surface through a thermal treatment.

The nano-photonic lens array 140 may be disposed on the planarization layer 130. FIGS. 3A and 3B show that the nano-photonic lens array 140 is directly disposed on the planarization layer 130, but a protective layer for preventing damage to the planarization layer 130 that is formed of an organic polymer material during the process of forming the nano-photonic lens array 140 may be disposed on the planarization layer 130, and then, the nano-photonic lens array 140 may be disposed on the protective layer. Also, in order to protect the planarization layer 130 while forming the nano-photonic lens array 140, an etch stop layer may be further arranged between the planarization layer 130 and the nano-photonic lens array 140.

The nano-photonic lens array 140 may be configured to color-separate incident light. For example, the nano-photonic lens array 140 may separate the light of first wavelength band (e.g., green light), the light of second wavelength band (e.g., blue light), and the light of third wavelength band (e.g., red light) from the incident light and allow the separated light to proceed in different passages. Also, the nano-photonic lens array 140 may be configured to act as a lens condensing light of the first wavelength band, light of the second wavelength band, and light of the third wavelength band that are color-separated onto pixels. In particular, the nano-photonic lens array 140 may be configured to condense, in the incident light, light of the first wavelength band onto the first pixel 111 and the fourth pixel 114, light of the second wavelength band onto the second pixel 112, and light of the third wavelength band onto the third pixel 113.

To condense light as described above, the nano-photonic lens array 140 may include a plurality of nano-structures NP that are periodically disposed according to a certain rule. Also, the nano-photonic lens array 140 may further include a dielectric layer DL filled among the plurality of nano-structures NP. In order for the nano-photonic lens array 140 to perform the above functions, the plurality of nano-structures NP of the nano-photonic lens array 140 may be variously formed.

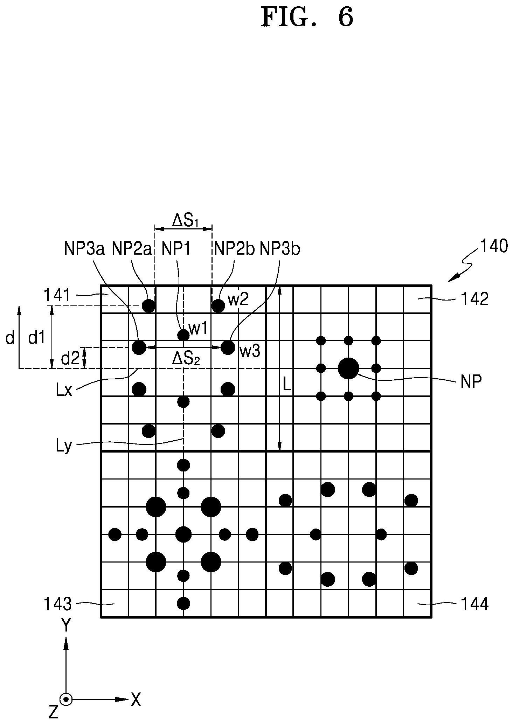

FIG. 6 is a plan view showing an example of a unit meta-pattern in the nano-photonic lens array 140 of FIGS. 3A and 3B. Referring to FIG. 6, the nano-photonic lens array 140 includes a first meta-region 141 corresponding to the first pixel 111, a second meta-region 142 corresponding to the second pixel 112, a third meta-region 143 corresponding to the third pixel 113, and a fourth meta-region 144 corresponding to the fourth pixel 114. The first meta-region 141 may be arranged to face the first pixel 111 in the third direction, the second meta-region 142 may be arranged to face the second pixel 112 in the third direction, the third meta-region 143 may be arranged to face the third pixel 113 in the third direction, and the fourth meta-region 144 may be arranged to face the fourth pixel 114 in the third direction. In one unit meta-pattern, the first meta-region 141 and the fourth meta-region 144 are arranged in the first diagonal direction, and the second meta-region 142 and the third meta-region 143 may be arranged in the second diagonal direction.

FIG. 6 shows only one unit meta-pattern as an example, but a plurality of first meta-regions 141 and a plurality of second meta-regions 142 may be alternately arranged in the first direction, and a plurality of third meta-regions 143 and a plurality of fourth meta-regions 144 may be alternately arranged in the first direction on a cross-section at a position that is different in the second direction perpendicular to the first direction. For example, the nano-photonic lens array 140 may include a plurality of unit meta-patterns that are periodically and two-dimensionally arranged in the first and second directions. The pattern period or lattice constant of the plurality of unit meta-patterns in the nano-photonic lens array 140 may be equal to those of the plurality of unit pixel patterns in the sensor substrate 110.

The nano-photonic lens array 140 may include a plurality of nano-structures NP that are two-dimensionally arranged respectively in the first to fourth meta-regions 141, 142, 143, and 144 so as to color-separate the incident light and condense the separated light. The plurality of nano-structures NP may be disposed so that a phase of light transmitting through the nano-photonic lens array 140 is changed according to a position on the nano-photonic lens array 140. A phase profile of the transmitted light, which is implemented by the nano-photonic lens array 140, may be determined according to a cross-sectional size (e.g., width or diameter), cross-sectional shape, and a height of each of the nano-structures NP, and the arrangement period (or pitch) and arrangement type of the plurality of nano-structures NP. Also, the behavior of the light passing through the nano-photonic lens array 140 may be determined according to the phase profile of the transmitted light. For example, the plurality of nano-structures NP may be disposed to form a phase profile allowing the light transmitted through the nano-photonic lens array 140 to be separated according to wavelengths and condensed.

The nano-structures NP may each have a size that is less than a wavelength of visible light. The nano-structures NP may have a size that is less than, for example, the blue wavelength. For example, the cross-sectional width (or diameter) of the nano-structures NP may be less than 400 nm, 300 nm, or 200 nm, and may be greater than about 80 nm. A height of the nano-structures NP may be about 500 nm to about 1500 nm, and may be greater than the cross-sectional width of the nano-structures NP.

The nano-structures NP may include a material having a relatively higher refractive index as compared with a peripheral material and having a relatively lower absorption ratio in the visible ray band. For example, the nano-structures NP may include c-Si, p-Si, a-Si and a Group III-V compound semiconductor (gallium phosphide (GaP), gallium nitride (GaN), gallium arsenide (GaAs) etc.), silicon carbide (SiC), titanium oxide ($TiO_2$), silicon nitride ($SiN_3$), zinc sulfide (ZnS), zinc selenide (ZnSe), $Si_3N_4$, and/or a combination thereof. Periphery of the nano-structures NP may be filled with the dielectric layer DL having a relatively lower refractive index as compared with the nano-structures NP and have a relatively low absorbent ratio in the visible ray band. For example, the dielectric layer DL may be filled with siloxane-based spin on glass (SOG), silicon oxide ($SiO_2$), $Si_3N_4$, aluminum oxide ($Al_2O_3$), air, etc.

The refractive index of the nano-structures NP may be about 2.0 or greater with respect to light of about a 630 nm wavelength, and the refractive index of the dielectric layer DL may be about 1.0 to about 2.0 or less with respect to light of about a 630 nm wavelength. Also, a difference between the refractive indexes of the nano-structures NP and the refractive index of the dielectric layer DL may be about 0.5 or greater. The nano-structures NP having a different refractive index from the refractive index of the peripheral material may change the phase of light that passes through the nano-structures NP. This phase change may be caused by phase delay that occurs due to the shape dimension of the sub-wavelength of the nanostructures NP, and a degree at which the phase is delayed may be determined by a detailed shape dimension and arrangement shape of the nanostructures NP.

In the example shown in FIG. 6, the plurality of nano-structures NP having different cross-sectional sizes may be arranged in each of the first meta-region 141, the second meta-region 142, the third meta-region 143, and the fourth meta-region 144. In the first meta-region 141, the second meta-region 142, the third meta-region 143, and the fourth meta-region 144, the arrangement types of the plurality of nano-structures NP may be different from each other. In the second meta-region 142 and the third meta-region 143, the plurality of nano-structures NP may be arranged in a 4-fold symmetry. For example, in the second meta-region 142 and the third meta-region 143, the plurality of nano-structures NP may be arranged to be symmetrical in all of the first direction (or horizontal direction), the second direction (or vertical direction), and two diagonal directions. In the first meta-region 141 and the fourth meta-region 144, the plurality of nano-structures NP may be arranged in a 2-fold symmetry. For example, in the first meta-region 141 and the fourth meta-region 144, the plurality of nano-structures NP may be arranged to be symmetrical in both the first direction (or horizontal direction) and the second direction (or vertical direction). For example, the arrangement type of the plurality of nano-structures NP in the fourth meta-region 144 may be rotated by 90-degree angle with respect to the arrangement of the plurality of nano-structures NP in the first meta-region 141.

FIG. 6 shows an example of the configuration of the nano-photonic lens array 140, and the nano-photonic lens array 140 may be formed in various shapes other than the example shown in FIG. 6. For example, in each of the first meta-region 141, the second meta-region 142, the third meta-region 143, and the fourth meta-region 144, cross-sectional sizes and arrangement type of the plurality of nano-structures NP may be variously selected. However, the arrangement types of the plurality of nano-structures NP in the second meta-region 142 and the third meta-region 143 being different from each other, the plurality of nano-structures NP being arranged in a 4-fold symmetry in the second meta-region 142 and the third meta-region 143, the plurality of nano-structures NP being arranged in a 2-fold symmetry in the first meta-region 141 and the fourth meta-region 144, and the arrangement type of the plurality of nano-structures NP in the first meta-region 141 being rotated by 90-degree angle with respect to the arrangement type of the plurality of nano-structures NP in the fourth meta-region 144, may be constantly maintained.

In FIG. 6, the nano-structures NP are shown to have cylindrical shapes, but cross-sectional shapes of the nano-structures NP are not limited thereto. For example, according to the configuration of the nano-photonic lens array 140, the nano-structures NP may be formed in pillar shapes having various different cross-sectional shapes such as rectangular shapes, triangular shapes, cross shapes, or elliptical shapes. When the cross-sectional shape of the nano-structure NP is a polygonal or an elliptical shape, the cross-sectional size of the nano-structure NP may be defined as a maximum width in the nano-structure NP. Therefore, the cross-sectional size of the nano-structure NP denotes the diameter when the cross-sectional shape of the nano-structure NP is circular and denotes a maximum width of the nano-structure NP when the cross-sectional shape of the nano-structure NP is a polygonal or oval shape. In addition, grid lines indicated by solid lines in the first meta-region 141, the second meta-region 142, the third meta-region 143, and the fourth meta-region 144 of FIG. 6 are shown to clearly express locations of the nano-structures and are not relevant with actual structures of the first to fourth meta-regions 141, 142, 143, and 144.

The first meta-region 141 may include a plurality of nano-structures arranged along a vertical center line Ly and a plurality of pairs of two nano-structures that are arranged symmetrically in the first direction at different distances from a horizontal center line Lx in the second direction. The horizontal center line Lx may be defined as a straight line passing through the center of the first meta-region 141 in the first direction, and the vertical center line Ly may be defined as a straight line passing through the center of the first meta-region 141 in the second direction.

For example, the first meta-region 141 may include a first nano-structure NP1 arranged along the vertical center line Ly, a second nano-structure NP2a and a third nano-structure NP2b arranged symmetrically with respect to the vertical center line Ly in the first direction, and a fourth nano-structure NP3a and a fifth nano-structure NP3b arranged symmetrically with respect to the vertical center line Ly in the first direction.

The second nano-structure NP2a and the third nano-structure NP2b may be separated by a first interval $\Delta S_1$ in the first direction, and the fourth nano-structure NP3a and the fifth nano-structure NP3b may be separated by a second interval $\Delta S_2$ in the first direction. The first interval $\Delta S_1$ and the second interval $\Delta S_2$ may be less than L/8 or less than 3L/8, wherein L denotes a length of a side of the first meta-region 141. The second interval $\Delta S_2$ may be greater than the first interval $\Delta S_1$.

A distance $d_2$ from the horizontal center line Lx to the pair of the fourth nano-structure NP3a and the fifth nano-structure NP3b having the second interval $\Delta S_2$, is less than a distance $d_1$ from the horizontal center line Lx to the pair of the second nano-structure NP2a and the third nano-structure NP2b so that a distance d from the horizontal center line Lx to a pair of nano-structures decreases when an interval between the paired nano-structures increases.

Hereinafter, descriptions are provided under the assumption that the light of first wavelength band is green light, light of the second wavelength band is blue light, and light of the third wavelength band is red light. However, one or more embodiments are not limited thereto. For example, light of the first wavelength band may be yellow light, light of the second wavelength band may be blue light, and light of the third wavelength band may be red light. According to another example embodiment, light of the first wavelength band may be yellow light, light of the second wavelength band may be cyan light, and light of the third wavelength band may be magenta light.

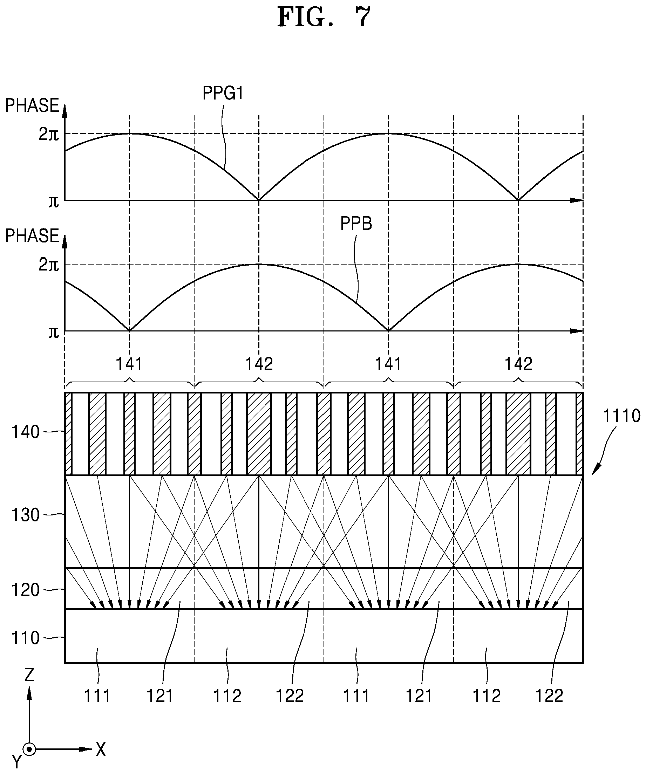

FIG. 7 is a diagram showing an example of phase profiles of green light and blue light after passing through the nano-photonic lens array 140 of FIG. 6. Referring to FIG. 7, the green light after passing through the nano-photonic lens array 140 may have a first green light phase profile PPG1 that is largest at the center of the first meta-region 141 and reduces away from the center of the first meta-region 141. For example, at a position immediately after passing through the nano-photonic lens array 140, that is, on the lower surface of the nano-photonic lens array 140, the phase of the green light is largest at the center of the first meta-region 141 and may decrease in a concentric circle form away from the center of the first meta-region 141.

The blue light that has passed through the nano-photonic lens array 140 may have a blue light phase profile PPB that is largest at the center of the second meta-region 142 and decreases away from the center of the second meta-region 142. For example, at a position immediately after passing through the nano-photonic lens array 140, that is, on the lower surface of the nano-photonic lens array 140, the phase of the blue light is largest at the center of the second meta-region 142 and may decrease in a concentric circle form away from the center of the second meta-region 142.

Then, in the incident light that is incident on the first meta-region 141 and the incident light that is incident on a portion of the second meta-region 142 and a portion of the third meta-region 143 around the first meta-region 141, the green light may be condensed onto a pixel corresponding to the first meta-region 141 by the nano-photonic lens array 140. Also, in the incident light incident on the second meta-region 142 and the incident light incident on a portion of the first meta-region 141, a portion of the third meta-region 143, and a portion of the fourth meta-region 144 around the second meta-region 142, the blue light is condensed onto a pixel corresponding to the second meta-region 142 by the nano-photonic lens array 140.

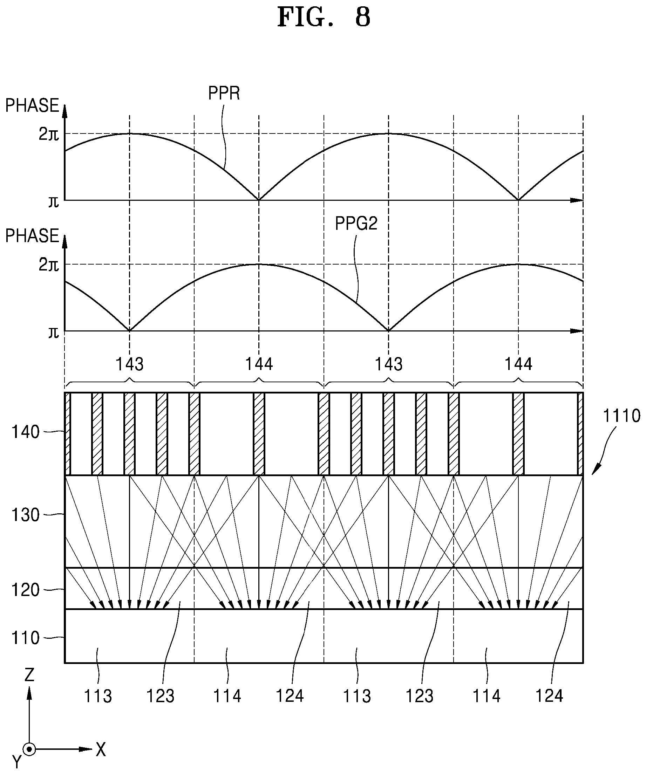

FIG. 8 is a diagram showing an example of phase profiles of red light and green light after passing through the nano-photonic lens array 140 of FIG. 6. Referring to FIG. 8, the red light after passing through the nano-photonic lens array 140 may have a red light phase profile PPR that is largest at the center of the third meta-region 143 and reduces away from the center of the third meta-region 143. For example, at a position immediately after passing through the nano-photonic lens array 140, the phase of the red light may be largest at the center of the third meta-region 143 and may decrease in a concentric circle form away from the center of the third meta-region 143.

The green light that has passed through the nano-photonic lens array 140 may have a second green light phase profile PPG2 that is largest at the center of the fourth meta-region 144 and decreases away from the center of the fourth meta-region 144. Except that the second green light phase profile PPG2 has the largest phase at the center of the fourth meta-region 144, the descriptions about the first green light phase profile PPG1 may be also applied to the second green light phase profile PPG2.

Then, in the incident light that is incident on the third meta-region 143 and the incident light that is incident on a portion of the first meta-region 141, a portion of the second meta-region 142, and a portion of the fourth meta-region 144 around the third meta-region 143, the red light may be condensed onto the pixel corresponding to the third meta-region 143 by the nano-photonic lens array 140. Also, in the incident light that is incident on the fourth meta-region 144 and the incident light that is incident on a portion of the second meta-region 142 and a portion of the third meta-region 143 around the fourth meta-region 144, the green light is condensed onto the pixel corresponding to the fourth meta-region 144 by the nano-photonic lens array 140.

Therefore, the nano-photonic lens array 140 may condense, in the incident light, green light onto the pixels corresponding to the first meta-region 141 and the fourth meta-region 144, blue light onto the pixel corresponding to the second meta-region 142, and red light onto the pixel corresponding to the third meta-region 143. Then, the incident light may be separated by the nano-photonic lens array 140 according to wavelengths without loss and may be condensed onto the pixels.

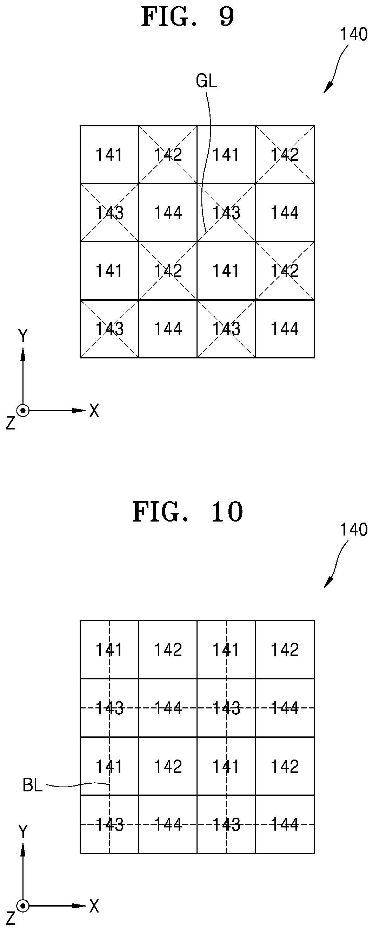

FIG. 9 is a diagram showing an example of an array of a green light condensing region formed by the nano-photonic lens array 140. Referring to FIG. 9, the phase profile of the green light described above with reference to FIGS. 7 and 8 may condense the green light onto the pixels corresponding to the first meta-region 141 and the fourth meta-region 144, wherein the green light has passed through a green light condensing region GL obtained by connecting centers of two second meta-regions 142 to centers of two third meta-regions 143, which are adjacent to the first meta-region 141 and the fourth meta-region 144 while contacting one sides thereof. Therefore, as shown in FIG. 9, the nano-photonic lens array 140 may act as an array of the green light condensing region GL condensing the green light onto the pixels corresponding to the first meta-region 141 and the fourth meta-region 144. The green light condensing region GL may have an area that is, for example, 1.2 to 2 times greater than that of the corresponding pixel.

FIG. 10 is a diagram showing an example of an array of a blue light condensing region formed by the nano-photonic lens array 140. Referring to FIG. 10, according to the phase profile of the blue light described with reference to FIG. 7, the blue light that has passed through a blue light condensing region BL obtained by connecting the centers of four third meta-regions 143 that are adjacent to the second meta-region 142 at apexes thereof may be condensed onto the pixel corresponding to the second meta-region 142. Therefore, as shown in FIG. 10, the nano-photonic lens array 140 may act as an array of the blue light condensing region BL condensing the blue light onto the pixel corresponding to the second meta-region 142. The blue light condensing region BL may have an area that is, for example, 1.5 to 4 times greater than that of the corresponding pixel. The blue light condensing region BL may partially overlap a portion of the green light condensing region GL and a portion of a red light condensing region RL that is described later.

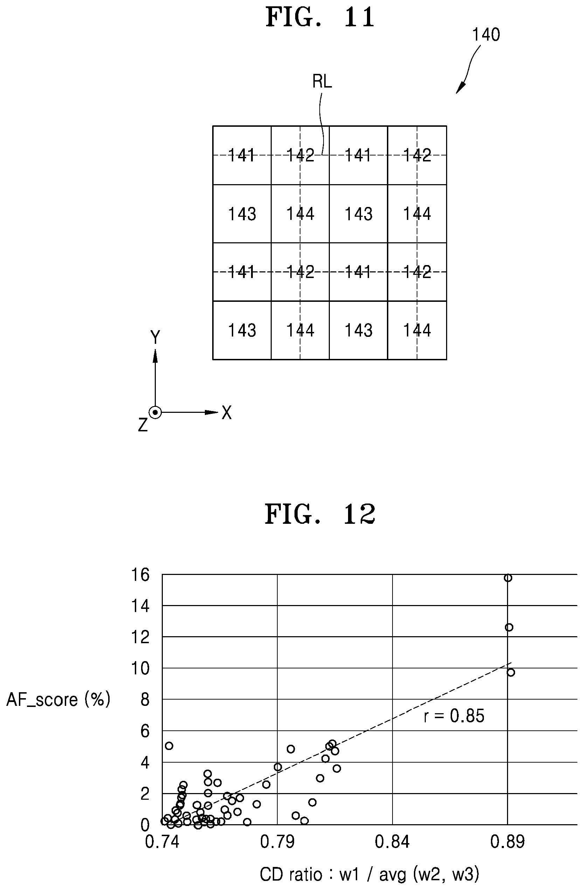

FIG. 11 is a diagram showing an example of an array of a red light condensing region formed by the nano-photonic lens array 140. Referring to FIG. 11, according to the phase profile of the red light described with reference to FIG. 8, the red light that has passed through the red light condensing region RL obtained by connecting the centers of four second meta-regions 142 that are adjacent to the third meta-region 143 at apexes thereof may be condensed onto the pixel corresponding to the third meta-region 143. Therefore, as shown in FIG. 11, the nano-photonic lens array 140 may act as an array of the red light condensing region RL condensing the red light onto the pixel corresponding to the third meta-region 143. The red light condensing region RL may have an area that is, for example, 1.5 to 4 times greater than that of the corresponding pixel. The red light condensing region RL may partially overlap a portion of the green light condensing region GL and a portion of the blue light condensing region BL.

According to an embodiment, because the nano-photonic lens array 140 described above may separate the incident light by wavelengths and condense the separated light without absorbing or blocking the incident light, the light utilization efficiency of an image sensor may be improved. Also, because the incident light is color-separated by the nano-photonic lens array 140 to a certain degree, the absorption loss because of the color filter layer 120 may be relatively low even when the color filter layer 120 is used. Also, color purity may be improved because the nano-photonic lens array 140 and the color filter layer 120 are used together.

In addition, as described above, the first meta-region 141 and the fourth meta-region 144 have the arrangements of the nano-structures, which are rotated by 90-degree angle with respect to each other, in the nano-photonic lens array 140. Therefore, a light spot of the light that has passed through the nano-photonic lens array 140 and is condensed onto the first pixel 111 corresponding to the first meta-region 141 and a light spot condensed onto the fourth pixel 114 corresponding to the fourth meta-region 144 may be rotated by 90-degree angle with respect to each other. As such, signals output from the first pixel 111 and the fourth pixel 114 forming two same color channels in one unit pixel pattern may be different from each other. For example, autofocusing (AF) characteristics of the first pixel 111 and the fourth pixel 114 may be different from each other, and modulation transfer function (MTF) characteristics of the first pixel 111 and the fourth pixel 114 may be different from each other.

An image processing algorithm of an image sensor according to the related art is assumed that two same color channels in one unit pixel pattern have the same characteristics. Therefore, in order to apply a general image processing algorithm to the image sensor 1000 according to the example embodiment, it is advantageous when difference between the signals output from the first pixel 111 and the fourth pixel 114 in one unit pixel pattern is reduced. To this end, although the first meta-region 141 and the fourth meta-region 144 have the 2-fold symmetry structure, the cross-sectional sizes and arrangement types of the plurality of nano-structures NP in the first meta-region 141 and the fourth meta-region 144 may be configured such that the shapes of the light spots formed respectively on the first pixel 111 and the fourth pixel 114 are close to the 4-fold symmetry.

Referring back to FIG. 6, the first meta-region 141 may include a plurality of nano-structures arranged on a vertical center line Ly and a plurality of pairs of two nano-structures that are arranged symmetrically in the first direction at different distances from a horizontal center line Lx in the second direction. For example, the first meta-region 141 may include a first nano-structure NP1 arranged on the vertical center line Ly, a second nano-structure NP2a and a third nano-structure NP2b arranged symmetrically with respect to the vertical center line Ly in the first direction, and a fourth nano-structure NP3a and a fifth nano-structure NP3b arranged symmetrically with respect to the vertical center line Ly in the first direction. The second nano-structure NP2a and the third nano-structure NP2b may be arranged adjacent to the edge of the first meta-region 141 in the second direction, and the fourth nano-structure NP3a and the fifth nano-structure NP3b may be arranged adjacent to the center of the first meta-region 141 in the second direction. For example, a distance between the second and third nano-structures NP2a and NP2b and the horizontal center line Lx in the second direction may be greater than a distance between the fourth and fifth nano-structures NP3a and NP3b and the horizontal center line Lx in the second direction. Here, the horizontal center line Lx may be defined as a straight line passing through the center of the first meta-region 141 in the first direction, and the vertical center line Ly may be defined as a straight line passing through the center of the first meta-region 141 in the second direction.

The first meta-region 141 may further include a plurality of nano-structures that are arranged symmetrically with the first to fifth nano-structures NP1, NP2a, NP2b, NP3a, and NP3b based on the horizontal center line Lx in the second direction. Hereinafter, the first to fifth nano-structures NP1, NP2a, NP2b, NP3a, and NP3b arranged above the horizontal center line Lx are only described. Because the first meta-region 141 has a symmetrical shape based on the horizontal center line Lx, the descriptions about the first to fifth nano-structures NP1, NP2a, NP2b, NP3a, and NP3b may be applied to the plurality of nano-structures arranged below the horizontal center line Lx.

Also, the fourth meta-region 144 is identical to the first meta-region 141, except that the fourth meta-region 144 is rotated by 90-degree angle with respect to the first meta-region 141. For example, the arrangement pattern described below with respect to the first meta-region 141 may be rotated by 90-degree angle and applied to the fourth meta-region 144. Therefore, the first meta-region 141 is described below, and descriptions about the fourth meta-region 144 are omitted.

The first nano-structure NP1 may have a first cross-sectional size w1, the second nano-structure NP2a and the third nano-structure NP2b may have a second cross-sectional size w2, and the fourth and fifth nano-structures NP3a and NP3b may have a third cross-sectional size w3. Also, the second and third nano-structures NP2a and NP2b may be arranged with a first interval $\Delta S_1$ in the first direction, and the fourth and fifth nano-structures NP3a and NP3b may be arranged with a second interval $\Delta S_2$ in the first direction. According to the embodiment, by appropriately selecting the relationship among the first cross-sectional size w1, the second cross-sectional size w2, and the third cross-sectional size w3 and the relationship between the first interval $\Delta S_1$ and the second interval $\Delta S_2$, the light spots respectively formed on the first pixel 111 and the fourth pixel 114 may have a shape close to the 4-fold symmetry, and accordingly, the difference between the signals output from the first pixel 111 and the fourth pixel 114 in one unit pixel pattern may be reduced or minimized.

FIG. 12 is a graph showing an example of a relationship between various geometrical shapes of a plurality of nano-structures of the nano-photonic lens array 140 and a difference in AF characteristics of the first pixel 111 and the fourth pixel 114 in one unit pixel pattern. In the graph of FIG. 12, a horizontal axis denotes a ratio of the first cross-sectional size w1 with respect to an average of the second cross-sectional size w2 and the third cross-sectional size w3 (hereinafter, referred to as a CD ratio) from among various optimization parameters of the plurality of nano-structures, and a vertical axis denotes a difference between a contrast ratio of an AF signal of the first pixel 111 and a contrast ratio of an AF signal of the fourth pixel 114 (hereinafter, referred to as "AF_score"). When a value of the vertical axis is "0", the AF signal of the first pixel 111 and the AF signal of the fourth pixel 114 are identical. AF_score may be defined by Equation 1 below.

[Equation 1]

$$AF\_score = \frac{|AF_{Gr} - AF_{Gb}|}{avg(AF_{Gr}, AF_{Gb})} \times 100(\%)$$

In Equation 1 above, $AF_{Gb}$ denotes a contrast ratio of the AF signal of the first pixel 111 and $AF_{Gr}$ denotes a contrast ratio of the AF signal of the fourth pixel 114.

Referring to FIG. 12, although there may be fluctuations according to values of other parameters than the cross-sectional sizes, it may be identified that there is a linear relationship between the CD ratio and the AF_score. For example, the CD ratio and AF_score may have a linear relationship in which a correlation coefficient (r) of the least-square method is about 0.85. When the CD ratio is about 0.74, the AF_score is close to zero, and as the CD ratio increases, the AF_score increases. Considering the results of FIG. 12, an average of the second cross-sectional size w2 and the third cross-sectional size w3 may be greater than the first cross-sectional size w1. This is because, when the nano-structures having large cross-sectional sizes on average are located at the outskirt of the first meta-region 141 in the first direction, the transmitted light is guided in the first direction and the light spot formed on the first pixel 111 is expanded in the first direction such that the light spot may be formed close to a circle shape. However, when the average cross-sectional size of the nano-structures located at the outskirt of the first meta-region 141 in the first direction is excessively large, the difference between the AF characteristics of the first pixel 111 and the fourth pixel 114 may be too large to use a general image processing algorithm.

Considering this, the CD ratio may be selected to be about 0.85 or less, about 0.7 to about 0.85, about 0.74 to about 0.85, about 0.7 to about 0.8, or about 0.74 to about 0.8. For example, a ratio of the first cross-sectional size w1 with respect to the average of the second and third cross-sectional sizes w2 and w3 may be about 0.85 or less, about 0.7 to about 0.85, about 0.74 to about 0.85, about 0.7 to about 0.8, or about 0.74 to about 0.8. When the plurality of nano-structures having different cross-sectional sizes are arranged on the vertical center line Ly in the second direction, the first cross-sectional size w1 may be the average of the cross-sectional sizes of the plurality of nano-structures. Therefore, the ratio of the average cross-sectional size of at least one nano-structure on the vertical center line Ly in the first meta-region 141 with respect to the average cross-sectional size of the plurality of nano-structures arranged symmetrically on the vertical center line Ly in the first direction in the first meta-region 141 is about 0.85 or less, about 0.7 to about 0.85, about 0.74 to about 0.85, or about 0.74 to about 0.8.

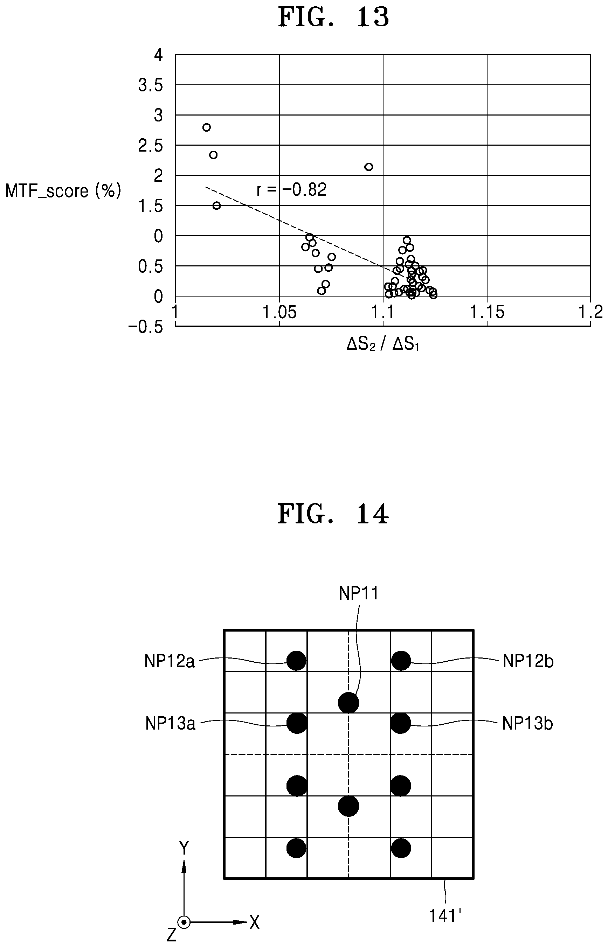

FIG. 13 is a graph showing an example of a relationship between various geometrical shapes of a plurality of nano-structures of the nano-photonic lens array 140 and a difference in MTF characteristics of the first pixel 111 and the fourth pixel 114 in one unit pixel pattern. In the graph of FIG. 13, the horizontal axis denotes a ratio ($\Delta S_2/\Delta S_1$) of the second interval $\Delta S_2$ with respect to the first interval $\Delta S_1$ from among various optimization parameters of the plurality of nano-structures, and the vertical axis denotes a difference between the MTF value of the first pixel 111 and the MTF value of the fourth pixel 114 (hereinafter, MTF_score). When the value of the vertical axis is "0", it may be considered that the MTF characteristic of the first pixel 111 and the MTF characteristic of the fourth pixel 114 are the same. The MTF_score may be defined by Equation 2 below.

[Equation 2]

$$MTF\_score = \frac{|MTF_{Gr} - MTF_{Gb}|}{avg(MTF_{Gr}, MTF_{Gb})} \times 100(\%)$$

In Equation 2 above, $MTF_{Gb}$ denotes the MTF value of the first pixel 111 and $MTF_{Gr}$ denotes the MTF value of the fourth pixel 114.

Referring to FIG. 13, although there may be fluctuations according to values of other parameters than the intervals, it may be identified that there is a negative (-) linear relationship between $\Delta S_2/\Delta S_1$ and the MTF_score. For example, the $\Delta S_2/\Delta S_1$ and MTF_score may have a negative linear relationship in which a correlation coefficient (r) of the least-square method is about -0.82. Also, when the value of $\Delta S_2/\Delta S_1$ is about 1.12, the MTF_score is close to 0, and as the value of $\Delta S_2/\Delta S_1$ becomes greater or less than about 1.12, the MTF_score further deviates from 0.

Considering the result of FIG. 13, the second interval $\Delta S_2$ between the fourth nano-structure NP3a and the fifth nano-structure NP3b may be greater than the first interval $\Delta S_1$ between the second nano-structure NP2a and the third nano-structure NP2b. For example, the interval between two symmetrical nano-structures in the first direction increases closer to the horizontal center line Lx in the second direction, and the interval between two symmetrical nano-structures may decrease away from the horizontal center line Lx in the second direction. According to another example embodiment, the interval between two symmetrical nano-structures may further reduce toward the edge of the first meta-region 141 in the second direction. Therefore, the interval in the first direction between two nano-structures that are symmetrically arranged on the horizontal center line Lx in the first direction may be the largest. Then, the center of the light spot is further expanded in the first direction, and then, the light spot may be closer to the spherical shape.

In the example of FIG. 13, when the value of $\Delta S_2/\Delta S_1$ is about 1.12, the MTF_score is 0, but the value of $\Delta S_2/\Delta S_1$ making the MTF_score zero may vary depending on the distance between the horizontal center line Lx and the nano-structure in the second direction.

For example, when the interval in the first direction between two nano-structures that are symmetrically arranged on the horizontal center line Lx in the first direction is A, A may have a value of L/8 to 3L/8 according to the configuration of the nano-photonic lens array 140.

The interval $\Delta S$ in the first direction between two symmetrical nano-structures arranged at a distance d from the horizontal center line Lx in the second direction may be less than A. For example, when it is assumed that the second nano-structure NP2a and the fourth nano-structure NP3a in the left side with respect to the vertical center line Ly are disposed within a certain distance range from one point on the horizontal center line Lx that is in the right side with respect to the vertical center line Ly and the third nano-structure NP2b and the fifth nano-structure NP3b in the right side with respect to the vertical center line Ly are disposed within a certain distance range from one point on the horizontal center line Lx in the left side with respect to the vertical center line Ly, an appropriate range of the interval $\Delta S$ in the first direction between two symmetrical nano-structures arranged at a distance d from the horizontal center line Lx in the second direction may satisfy the condition defined by Equation 3 below.

[Equation 3]

$$2L(0.13-0.47y^2)<\Delta S<2L(0.38-0.96y^2-0.89y^4-1.63y^6)$$

Here, L denotes a length of one side of the first meta-region 141, y=d/L, and 0 < y < 0.5.

FIG. 14 is a plan view showing a structure of a nano-photonic lens array according to a related example. FIG. 14 shows an example of an arrangement of a plurality of nano-structures arranged in a first meta-region 141' of a nano-photonic lens array according to a related example. In the first meta-region 141' of the nano-photonic lens array according to the related example, a cross-sectional size of a nano-structure NP11 arranged on a vertical center line is equal to cross-sectional sizes of a plurality of nano-structures NP12a, NP12b, NP13a, and NP13b that are symmetrically arranged in the first direction with respect to the vertical center line. Also, an interval in the first direction between two nano-structures NP12a and NP12b and an interval in the first direction between two nano-structures NP13a and NP13b, for the two nano-structures NP12a and NP12b and two nano-structures NP13a and NP13b being arranged symmetrically in the first direction, do not satisfy the condition defined by Equation 3 above.

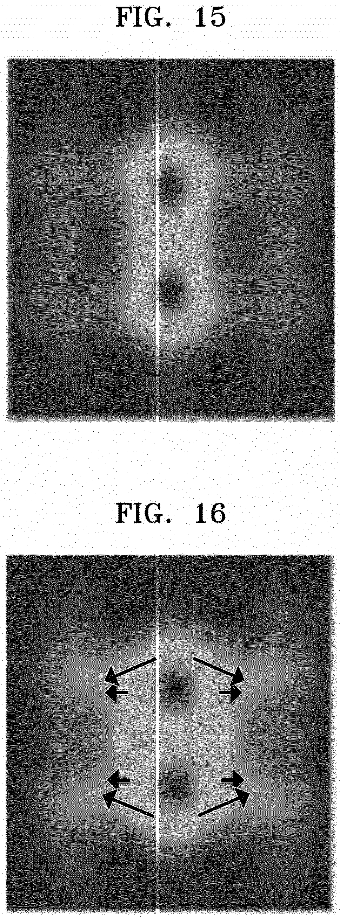

FIG. 15 shows an example of a light spot of green light formed on the first pixel 111 by the nano-photonic lens array according to the related example. Referring to FIG. 15, when the nano-photonic lens array according to the related example is used, the light spot of the green light formed on the first pixel 111 may have a 2-fold symmetry shape. For example, the light spot of the green light formed on the first pixel 111 may have the 2-fold symmetry shape that is longer in the second direction. Although not shown in the drawings, the light spot of the green light formed on the fourth pixel 114 may have a 2-fold symmetry shape that is longer in the first direction.

FIG. 16 shows an example of a light spot of green light formed on the first pixel 111 by the nano-photonic lens array 140 according to the embodiment. Referring to FIG. 16, when the nano-photonic lens array according to the embodiment is used, the light spot of the green light formed on the first pixel 111 may be further expanded in the first direction as compared with the related example. Then, the light spot of the green light may be closer to the 4-fold symmetry as compared with the related example. Therefore, the difference between signals output from the first pixel 111 and the fourth pixel 114 in one unit pixel pattern may be less than that of the related example.

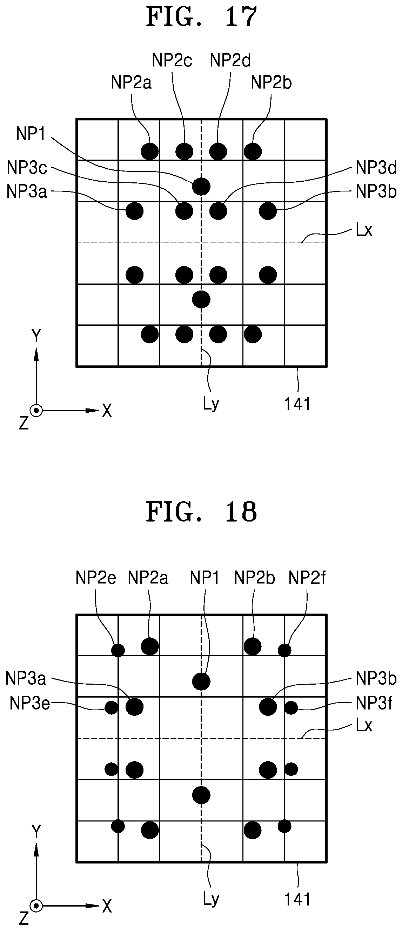

FIG. 17 is a plan view showing another example of the first meta-region 141 in the nano-photonic lens array 140. In the first meta-region 141 of FIG. 6, one pair of symmetrical nano-structures are arranged at the same distance from the horizontal center line Lx in the second direction. However, embodiments are not limited thereto, and as shown in FIG. 17, a plurality of pairs of symmetrical nano-structures may be arranged at the same distance from the horizontal center line Lx in the second direction. For example, the first meta-region 141 may include a first pair of the second nano-structure NP2a and the third nano-structure NP2b and a second pair of a sixth nano-structure NP2c and a seventh nano-structure NP2d. The second nano-structure NP2a and the third nano-structure NP2b, and the sixth nano-structure NP2c and the seventh nano-structure NP2d are symmetrically arranged in the first direction with respect to the vertical center line Ly at a first distance from the horizontal center line Lx in the second direction. Also, the first meta-region 141 may further include a third pair of the fourth nano-structure NP3a and the fifth nano-structure NP3b and a fourth pair of an eighth nano-structure NP3c and a ninth nano-structure NP3d, wherein the fourth nano-structure NP3a and the fifth nano-structure NP3b, and the eighth nano-structure NP3c and the ninth nano-structure NP3d are symmetrically arranged in the first direction with respect to the vertical center line Ly at a second distance less than the first distance from the horizontal center line Lx in the second direction.

In this case, the above conditions for reducing the difference between the signals output from the first pixel 111 and the fourth pixel 114 may be only applied to the nano-structures arranged at the outermost side in the first direction, the nano-structures that are closest to both sides of the first meta-region 141 in the first direction, or the nano-structures arranged with the largest interval in the first direction. In the example shown in FIG. 17, from among the plurality of nano-structures arranged at the first distance from the horizontal center line Lx in the second direction, the interval between the first pair of nano-structures NP2a and NP2b in the first direction is greater and the interval between the second pair of the nano-structures NP2c and NP2d in the first direction is smaller. From among the plurality of nano-structures arranged at the second distance from the horizontal center line Lx in the second direction, the interval between the third pair of nano-structures NP3a and NP3b in the first direction is greater and the interval between the fourth pair of nano-structures NP3c and NP3d in the first direction is smaller. Therefore, the above conditions for reducing the difference between the signals output from the first pixel 111 and the fourth pixel 114 may be only applied to the first pair of nano-structures NP2a and NP2b and the third pair of nano-structures NP3a and NP3b, and may not be applied to the second pair of nano-structures NP2c and NP2d and the fourth pair of nano-structures NP3c and NP3d.

For example, the ratio of the average cross-sectional size of the first nano-structure NP1 with respect to the average cross-sectional size of the first pair of nano-structures NP2a and NP2b and the third pair of nano-structures NP3a and NP3b may be about 0.85 or less, about 0.7 to about 0.85, about 0.74 to about 0.85, or about 0.74 to about 0.8. Also, the interval in the first direction between the third pair of nano-structures NP3a and NP3b may be greater than the interval in the first direction between the first pair of nano-structures NP2a and NP2b. For example, the interval between the first pair of nano-structures NP2a and NP2b in the first direction and the interval between the third pair of nano-structures NP3a and NP3b in the first direction may satisfy the condition defined by Equation 3 above.

FIG. 18 is a plan view showing another example of the first meta-region 141 in the nano-photonic lens array 140. In the nano-photonic lens array 140, nano-structures having the cross-sectional size greater than 80 nm are mainly arranged, but nano-structures having the cross-sectional size of 80 nm or less may be further arranged in order to finely adjust the transmitted light. Referring to FIG. 18, the first meta-region 141 may include a first pair of the second nano-structure NP2a and the third nano-structure NP2b and a fifth pair of a tenth nano-structure NP2e and an eleventh nano-structure NP2f, which are arranged symmetrically in the first direction with respect to the vertical center line Ly at the first distance from the horizontal center line Lx in the second direction. Also, the first meta-region 141 may further include a third pair of the fourth nano-structure NP3a and the fifth nano-structure NP3b and a sixth pair of a twelfth nano-structure NP3e and a thirteenth nano-structure NP3f, which are symmetrically arranged in the first direction with respect to the vertical center line Ly at a second distance less than the first distance from the horizontal center line Lx in the second direction. According to the example embodiment, the second nano-structure NP2a, the third nano-structure NP2b, the fourth nano-structure NP3a, and the fifth nano-structure NP3b may have the cross-sectional sizes greater than 80 nm, and the tenth nano-structure NP2e, the eleventh nano-structure NP2f, the twelfth nano-structure NP3e, and the thirteenth nano-structure NP3f may have the cross-sectional sizes less than or equal to 80 nm.

In this case, the above conditions for reducing the difference between the signals output from the first pixel 111 and the fourth pixel 114 may not be applied to the nano-structures having the cross-sectional sizes of 80 nm or less, and may be applied only to the nano-structures having the cross-sectional sizes greater than 80 nm. In the example shown in FIG. 18, the above conditions are not applied to the tenth nano-structure NP2e, the eleventh nano-structure NP2f, the twelfth nano-structure NP3e, and the thirteenth nano-structure NP3f having the cross-sectional sizes less than or equal to 80 nm. Therefore, the ratio of the average cross-sectional size of the first nano-structure NP1 with respect to the average cross-sectional size of the first pair of nano-structures NP2a and NP2b and the third pair of nano-structures NP3a and NP3b may be about 0.85 or less, about 0.7 to about 0.85, about 0.74 to about 0.85, or about 0.74 to about 0.8. Also, the interval in the first direction between the third pair of nano-structures NP3a and NP3b may be greater than the interval in the first direction between the first pair of nano-structures NP2a and NP2b. For example, the interval between the first pair of nano-structures NP2a and NP2b in the first direction and the interval between the third pair of nano-structures NP3a and NP3b in the first direction may satisfy the condition defined by Equation 3 above.

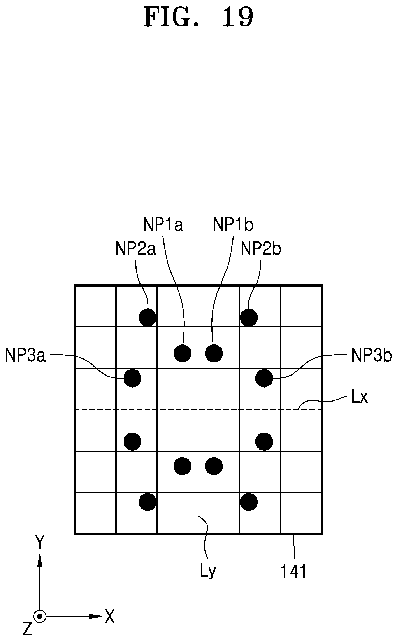

FIG. 19 is a plan view showing another example of the first meta-region 141 in the nano-photonic lens array 140. Referring to FIG. 19, the nano-structures may not be arranged on the vertical center line Ly. In this case, the nano-structures arranged closest to the vertical center line Ly in the first direction may act as the first nano-structure NP1 arranged on the vertical center line Ly shown in FIG. 6. For example, the first meta-region 141 may include a first-1 nano-structure NP1a and a first-2 nano-structure NP1b that are symmetrically arranged with respect to the vertical center line Ly in the first direction. An interval between the first-1 nano-structure NP1a and the first-2 nano-structure NP1b in the first direction may be less than that of the second nano-structure NP2a and the third nano-structure NP2b and may be less than that of the fourth nano-structure NP3a and the fifth nano-structure NP3b. In this case, an average cross-sectional size of the first-1 nano-structure NP1a and the first-2 nano-structure NP1b may be less than the average cross-sectional size of the second to fifth nano-structures NP2a, NP2b, NP3a, and NP3b. For example, a ratio of the average cross-sectional size of the first-1 nano-structure NP1a and the first-2 nano-structure NP1b with respect to the average cross-sectional size of the second to fifth nano-structures NP2a, NP2b, NP3a, and NP3b may be about 0.85 or less, about 0.7 to about 0.85, about 0.74 to about 0.85, or about 0.75 to about 0.8.

FIG. 19 shows that the first-1 nano-structure NP1a and the first-2 nano-structure NP1b are arranged between the second and third nano-structures NP2a and NP2b and the fourth and fifth nano-structures NP3a and NP3b from the horizontal center line Lx in the second direction, but embodiments are not limited thereto. The positions of the first-1 nano-structure NP1a and the first-2 nano-structure NP1b from the horizontal center line Lx in the second direction may be closer to the horizontal center line Lx than the fourth and fifth nano-structures NP3a and NP3b or may be closer to the edge of the first meta-region 141 in the second direction than the second and third nano-structures NP2a and NP2b.

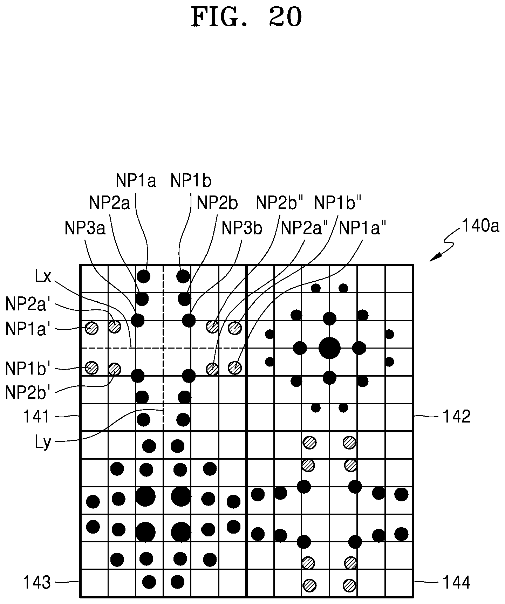

FIG. 20 is a plan view showing another example of one unit meta-pattern in a nano-photonic lens array 140a. Referring to FIG. 20, in the first meta-region 141 and the second meta-region 144 of the nano-photonic lens array 140a, the nano-structures may be arranged to have a 4-fold symmetry structure or have a structure that approximates to the 4-fold symmetry. For example, the first meta-region 141 may include the first-1 nano-structure NP1a, the first-2 nano-structure NP1b, the second nano-structure NP2a, the third nano-structure NP2b, the fourth nano-structure NP3a, and the fifth nano-structure NP3b that are arranged to satisfy the above conditions for reducing the difference between signals output from the first pixel 111 and the fourth pixel 114. In order for the first meta-region 141 to have the 4-fold symmetry structure or the structure that approximates to the 4-fold symmetry, the fourth nano-structure NP3a may be arranged on a first diagonal line passing through the center of the first meta-region 141 and the fifth nano-structure NP3b may be arranged on a second diagonal line passing through the center of the first meta-region 141 and crossing the first diagonal line.

Also, the first meta-region 141 may further include additional nano-structures that are arranged to be symmetrical to the first-1 nano-structure NP1a, the first-2 nano-structure NP1b, the second nano-structure NP2a, and the third nano-structure NP2b with respect to the first diagonal line and the second diagonal line, respectively. For example, the first meta-region 141 includes a first additional nano-structure NP1a', a second additional nano-structure NP1b', a third additional nano-structure NP2a', and a fourth additional nano-structure NP2b' that are arranged to be symmetrical respectively to the first-1 nano-structure NP1a, the first-2 nano-structure NP1b, the second nano-structure NP2a, and the third nano-structure NP2b with respect to the first diagonal line, and a fifth additional nano-structure NP1a", a sixth additional nano-structure NP1b", a seventh additional nano-structure NP2a", and an eighth additional nano-structure NP2b" that are arranged to be symmetrical respectively to the first-1 nano-structure NP1a, the first-2 nano-structure NP1b, the second nano-structure NP2a, and the third nano-structure NP2b with respect to the second diagonal line.

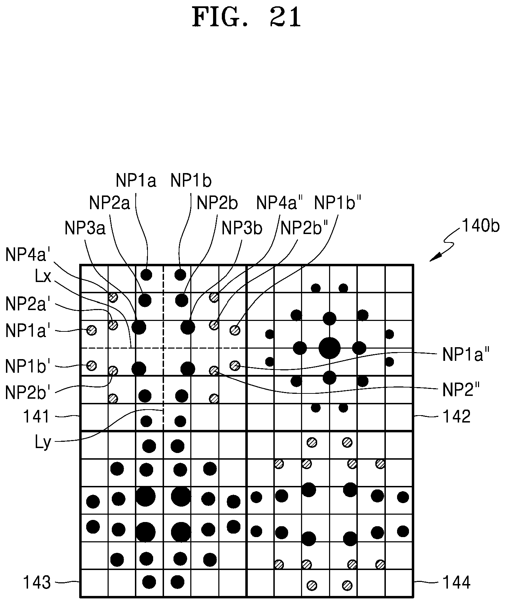

FIG. 21 is a plan view showing another example of one unit meta-pattern in a nano-photonic lens array 140b. In the example shown in FIG. 20, when the additional nano-structures that are added for the 4-fold symmetry structure or approximate 4-fold symmetry structure have the cross-sectional sizes greater than 80 nm, the color-separation performance of the nano-photonic lens array 140a may degrade and the optical efficiency may degrade. Referring to FIG. 21, the first meta-region 141 and the fourth meta-region 144 of the nano-photonic lens array 140b may include additional nano-structures having cross-sectional sizes less than or equal to 80 nm for the 4-fold symmetry or approximate 4-fold symmetry structure. For example, the first additional nano-structure NP1a', the second additional nano-structure NP1b', the third additional nano-structure NP2a', the fourth additional nano-structure NP2b', the fifth additional nano-structure NP1a", the sixth additional nano-structure NP1b", the seventh additional nano-structure NP2a", and the eighth additional nano-structure NP2b" may each have the cross-sectional size of 80 nm or less. Also, the first meta-region 141 may further include a ninth additional nano-structure NP4a' arranged on the first diagonal line, and a tenth additional nano-structure NP4a" arranged on the second diagonal line. The ninth additional nano-structure NP4a' and the tenth additional nano-structure NP4a" may have the cross-sectional size of 80 nm or less.

In the image sensor 1000 according to the example embodiment, the nano-photonic lens array 140 may color-separate the incident light without absorbing or reflecting the incident light and then condense the color-separated light onto each pixel, and thus, the light utilization efficiency may be improved and the degradation in resolution may be reduced. Therefore, a size of one pixel or size of independent photosensitive cells in the pixel of the image sensor 1000 may be reduced, and thus, the image sensor 1000 having higher resolution may be provided. Also, according to the example embodiment, an image processing algorithm in an image sensor according to the related art may be used while using the nano-photonic lens array 140. The image sensor 1000 according to the example embodiment may form a camera module along with a module lens of various functions and may be utilized in various electronic devices.

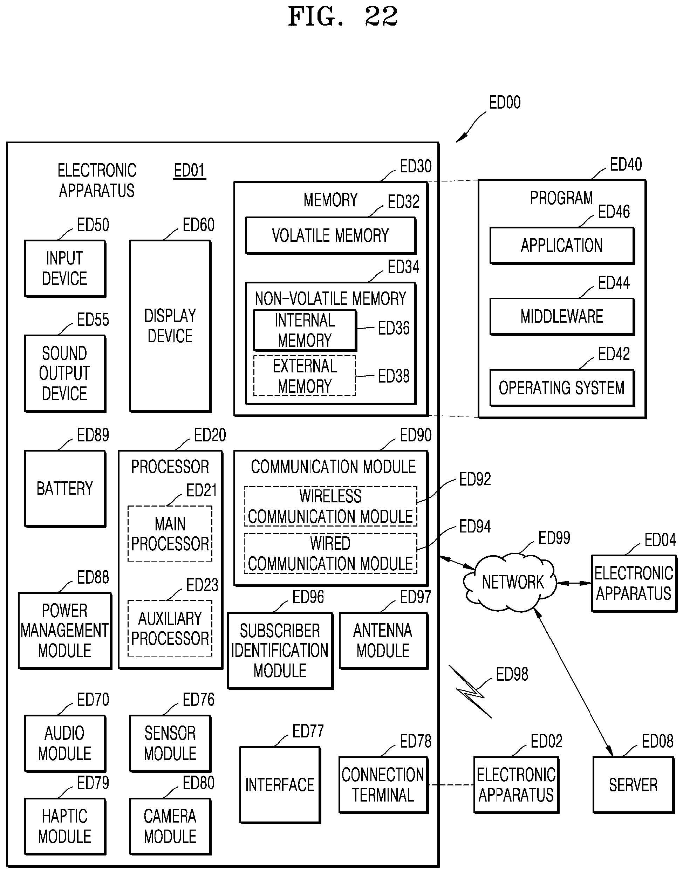

FIG. 22 is a block diagram showing an example of an electronic apparatus ED01 including an image sensor 1000. Referring to FIG. 22, in a network environment ED00, the electronic apparatus ED01 may communicate with another electronic apparatus ED02 via a first network ED98 (short-range wireless communication network, etc.), or may communicate with another electronic apparatus ED04 and/or a server ED08 via a second network ED99 (long-range wireless communication network, etc.). The electronic apparatus ED01 may communicate with the electronic apparatus ED04 via the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. In the electronic apparatus ED01, some (the display device ED60, etc.) of the elements may be omitted or another element may be added. Some of the elements may be configured as one integrated circuit. For example, the sensor module ED76 (a fingerprint sensor, an iris sensor, an illuminance sensor, etc.) may be embedded and implemented in the display device ED60 (display, etc.).

The processor ED20 may control one or more elements (hardware, software elements, etc.) of the electronic apparatus ED01 connected to the processor ED20 by executing software (program ED40, etc.) and may perform various data processing or operations. As a part of the data processing or operations, the processor ED20 may load a command and/or data received from another element (sensor module ED76, communication module ED90, etc.) to a volatile memory ED32, may process the command and/or data stored in the volatile memory ED32, and may store result data in a non-volatile memory ED34. The non-volatile memory ED34 may include an internal memory ED36 and an external memory ED38. The processor ED20 may include a main processor ED21 (a central processing unit, an application processor, etc.) and an auxiliary processor ED23 (a graphics processing unit, an image signal processor, a sensor hub processor, a communication processor, etc.) that may operate independently from or along with the main processor ED21. The auxiliary processor ED23 may use less power than that of the main processor ED21 and may perform specific functions.

The auxiliary processor ED23, on behalf of the main processor ED21 while the main processor ED21 is in an inactive state (sleep state) or along with the main processor ED21 while the main processor ED21 is in an active state (application executed state), may control functions and/or states related to some (the display device ED60, the sensor module ED76, the communication module ED90, etc.) of the elements in the electronic apparatus ED01. The auxiliary processor ED23 (an image signal processor, a communication processor, etc.) may be implemented as a part of another element (the camera module ED80, the communication module ED90, etc.) that is functionally related thereto.

The memory ED30 may store various data required by the elements (the processor ED20, the sensor module ED76, etc.) of the electronic apparatus ED01. The data may include, for example, input data and/or output data about software (program ED40, etc.) and commands related thereto. The memory ED30 may include the volatile memory ED32 and/or the non-volatile memory ED34.

The program ED40 may be stored as software in the memory ED30 and may include an operation system ED42, middleware ED44, and/or an application ED46.

The input device ED50 may receive commands and/or data to be used in the elements (the processor ED20, etc.) of the electronic apparatus ED01, from outside (a user, etc.) of the electronic apparatus ED01. The input device ED50 may include a microphone, a mouse, a keyboard, and/or a digital pen (stylus pen).

The sound output device ED55 may output a sound signal to outside of the electronic apparatus ED01. The sound output device ED55 may include a speaker and/or a receiver. The speaker may be used for a general purpose such as multimedia reproduction or record play, and the receiver may be used to receive a call. The receiver may be coupled as a part of the speaker or may be implemented as an independent device.

The display device ED60 may provide visual information to outside of the electronic apparatus ED01. The display device ED60 may include a display, a hologram device, or a projector, and a control circuit for controlling the corresponding device. The display device ED60 may include touch circuitry set to sense a touch, and/or a sensor circuit (pressure sensor, etc.) that is set to measure the strength of a force generated by the touch.

The audio module ED70 may convert sound into an electrical signal or vice versa. The audio module ED 70 may acquire sound through the input device ED50, or may output sound via the sound output device ED55 and/or a speaker and/or headphones of another electronic apparatus (the electronic apparatus ED02, etc.) connected directly or wirelessly to the electronic apparatus ED01.

The sensor module ED76 may sense an operating state (power, temperature, etc.) of the electronic apparatus ED01, or an outer environmental state (user state, etc.) and may generate an electrical signal and/or data value corresponding to the sensed state. The sensor module ED76 may include a gesture sensor, a gyro-sensor, a pressure sensor, a magnetic sensor, an acceleration sensor, a grip sensor, a proximity sensor, a color sensor, an infrared (IR) ray sensor, a vivo sensor, a temperature sensor, a humidity sensor, and/or an illuminance sensor.

The interface ED77 may support one or more designated protocols that may be used in order for the electronic apparatus ED01 to be directly or wirelessly connected to another electronic apparatus (the electronic apparatus ED02, etc.). The interface ED77 may include a high-definition multimedia interface (HDMI), a universal serial bus (USB) interface, an SD card interface, and/or an audio interface.

The connection terminal ED78 may include a connector by which the electronic apparatus ED01 may be physically connected to another electronic apparatus (the electronic apparatus ED02, etc.). The connection terminal ED78 may include an HDMI connector, a USB connector, an SD card connector, and/or an audio connector (headphones connector, etc.).

The haptic module ED79 may convert the electrical signal into a mechanical stimulation (vibration, motion, etc.)

or an electric stimulation that the user may sense through a tactile or motion sensation. The haptic module ED79 may include a motor, a piezoelectric device and/or an electric stimulus device.

The camera module ED80 may capture a still image and a video. The camera module ED80 may include a lens assembly including one or more lenses, the image sensor 1000 of FIG. 1, image signal processors, and/or flashes. The lens assembly included in the camera module ED80 may collect light emitted from an object that is an object to be captured.

The power management module ED88 may manage the power supplied to the electronic apparatus ED01. The power management module ED88 may be implemented as a part of a power management integrated circuit (PMIC).

The battery ED89 may supply electric power to components of the electronic apparatus ED01. The battery ED89 may include a primary battery that is not rechargeable, a secondary battery that is rechargeable, and/or a fuel cell.

The communication module ED90 may support the establishment of a direct (wired) communication channel and/or a wireless communication channel between the electronic apparatus ED01 and another electronic apparatus (the electronic apparatus ED02, the electronic apparatus ED04, the server ED08, etc.), and execution of communication through the established communication channel. The communication module ED90 may be operated independently from the processor ED20 (application processor, etc.) and may include one or more communication processors that support the direct communication and/or the wireless communication. The communication module ED90 may include a wireless communication module ED92 (a cellular communication module, a short-range wireless communication module, a global navigation satellite system (GNSS) communication module) and/or a wired communication module ED94 (a local area network (LAN) communication module, a power line communication module, etc.). From among the communication modules, a corresponding communication module may communicate with another electronic apparatus via the first network ED98 (short-range communication network such as Bluetooth, WiFi direct, or infrared data association (IrDA)) or a second network ED99 (long-range communication network such as a cellular network, Internet, or computer network (LAN, WAN, etc.)). Such above various kinds of communication modules may be integrated as one element (single chip, etc.) or may be implemented as a plurality of elements (a plurality of chips) separately from one another. The wireless communication module ED92 may identify and authenticate the electronic apparatus ED01 in a communication network such as the first network ED98 and/or the second network ED99 by using subscriber information (international mobile subscriber identifier (IMSI), etc.) stored in the subscriber identification module ED96.

The antenna module ED97 may transmit or receive the signal and/or power to/from outside (another electronic apparatus, etc.). An antenna may include a radiator formed as a conductive pattern formed on a substrate (PCB, etc.). The antenna module ED97 may include one or more antennas. When the antenna module ED97 includes a plurality of antennas, from among the plurality of antennas, an antenna that is suitable for the communication type used in the communication network such as the first network ED98 and/or the second network ED99 may be selected by the communication module ED90. The signal and/or the power may be transmitted between the communication module ED90 and another electronic apparatus via the selected antenna. Another component (RFIC, etc.) other than the antenna may be included as a part of the antenna module ED97.

Some of the elements may be connected to one another via the communication method among the peripheral devices (bus, general purpose input and output (GPIO), serial peripheral interface (SPI), mobile industry processor interface (MIPI), etc.) and may exchange signals (commands, data, etc.).

The command or data may be transmitted or received between the electronic apparatus ED01 and the external electronic apparatus ED04 via the server ED08 connected to the second network ED99. Other electronic apparatuses ED02 and ED04 may be the devices that are the same as or different kinds from the electronic apparatus ED01. All or some of the operations executed in the electronic apparatus ED01 may be executed in one or more devices among the other electronic apparatuses ED02, ED04, and ED08. For example, when the electronic apparatus ED01 has to perform a certain function or service, the electronic apparatus ED01 may request one or more other electronic apparatuses to perform some or entire function or service, instead of executing the function or service by itself. One or more electronic apparatuses receiving the request execute an additional function or service related to the request and may transfer a result of the execution to the electronic apparatus ED01. To do this, for example, a cloud computing, a distributed computing, or a client-server computing technique may be used.

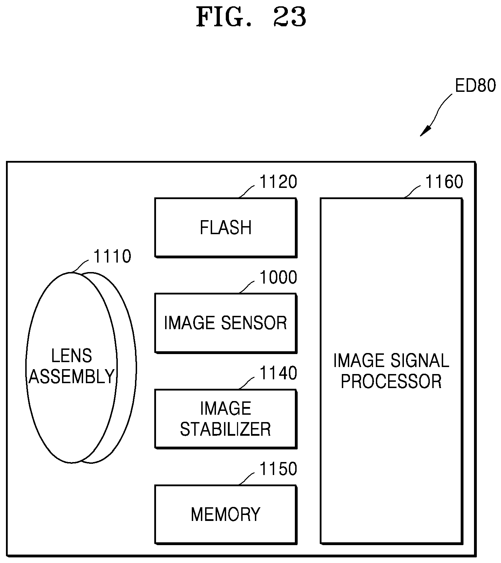

FIG. 23 is a block diagram showing an example of the camera module ED80 included in the electronic apparatus ED01 of FIG. 22. Referring to FIG. 23, the camera module ED80 may include a lens assembly 1110, a flash 1120, an image sensor 1000, an image stabilizer 1140, a memory 1150 (buffer memory, etc.), and/or an image signal processor 1160. The lens assembly 1110 may collect light emitted from an object that is to be captured. The camera module ED80 may include a plurality of lens assemblies 1110, and in this case, the camera module ED80 may include a dual camera module, a 360-degree camera, or a spherical camera. Some of the plurality of lens assemblies 1110 may have the same lens properties (viewing angle, focal length, auto-focus, F number, optical zoom, etc.) or different lens properties. The lens assembly 1110 may include a wide-angle lens or a telephoto lens.

The flash 1120 may emit light that is used to strengthen the light emitted or reflected from the object. The flash 1120 may emit visible light or infrared-ray light. The flash 1120 may include one or more light-emitting diodes (red-green-blue (RGB) LED, white LED, infrared LED, ultraviolet LED, etc.), and/or a Xenon lamp. The image sensor 1000 may be the image sensor described above with reference to FIG. 1, and converts the light emitted or reflected from the object and transferred through the lens assembly 1110 into an electrical signal to obtain an image corresponding to the object.

The image stabilizer 1140, in response to a motion of the camera module ED80 or the electronic apparatus ED01 including the camera module ED80, moves one or more lenses included in the lens assembly 1110 or the image sensor 1000 in a certain direction or controls the operating characteristics of the image sensor 1000 (adjusting of a read-out timing, etc.) in order to compensate for a negative influence of the motion. The image stabilizer 1140 may sense the movement of the camera module ED80 or the electronic apparatus ED01 by using a gyro sensor (not shown) or an acceleration sensor (not shown) disposed in or out of the camera module ED80. The image stabilizer 1140 may be implemented as an optical type.

The memory 1150 may store some or entire data of the image obtained through the image sensor 1000 for next image processing operation. For example, when a plurality of images are obtained at a high speed, obtained original data (Bayer-patterned data, high-resolution data, etc.) is stored in the memory 1150, and a low-resolution image is only displayed. Then, original data of a selected image (user selection, etc.) may be transferred to the image signal processor 1160. The memory 1150 may be integrated with the memory ED30 of the electronic apparatus ED01, or may include an additional memory that is operated independently.

The image signal processor 1160 may perform image treatment on the image obtained through the image sensor 1000 or the image data stored in the memory 1150. The image treatments may include a depth map generation, a three-dimensional modeling, a panorama generation, extraction of features, an image combination, and/or an image compensation (noise reduction, resolution adjustment, brightness adjustment, blurring, sharpening, softening, etc.). The image signal processor 1160 may perform controlling (exposure time control, read-out timing control, etc.) of the elements (image sensor 1000, etc.) included in the camera module ED80. Also, the image signal processor 1160 may generate a full-color image by executing a demosaic algorithm. For example, when the demosaic algorithm is executed to generate the full-color image, the image signal processor 1160 may reconstruct most of the spatial resolution information by using an image signal of a green channel or yellow channel having high spatial sampling rate.

The image processed by the image signal processor 1160 may be stored again in the memory 1150 for additional process, or may be provided to an external element of the camera module ED80 (e.g., the memory ED30, the display device ED60, the electronic apparatus ED02, the electronic apparatus ED04, the server ED08, etc.). The image signal processor 1160 may be integrated with the processor ED20, or may be configured as an additional processor that is independently operated from the processor ED20. When the image signal processor 1160 is configured as an additional processor separately from the processor ED20, the image processed by the image signal processor 1160 undergoes through an additional image treatment by the processor ED20 and then may be displayed on the display device ED60.

Also, the image signal processor 1160 may receive two output signals independently from the adjacent photosensitive cells in each pixel or sub-pixel of the image sensor 1000, and may generate an auto-focusing signal from a difference between the two output signals. The image signal processor 1160 may control the lens assembly 1110 such that the focus of the lens assembly 1110 may be accurately formed on the surface of the image sensor 1000 based on the auto-focusing signal.

The electronic apparatus ED01 may further include one or a plurality of camera modules having different properties or functions. The camera module may include elements similar to those of the camera module ED80 of FIG. 23, and the image sensor included in the camera module may be implemented as a CCD sensor and/or a CMOS sensor and may include one or a plurality of sensors selected from the image sensors having different properties, such as an RGB sensor, a black and white (BW) sensor, an IR sensor, or a UV sensor. In this case, one of the plurality of camera modules ED80 may include a wide-angle camera and another camera module ED80 may include a telephoto camera. Similarly, one of the plurality of camera modules ED80 may include a front camera and another camera module ED80 may include a rear camera.

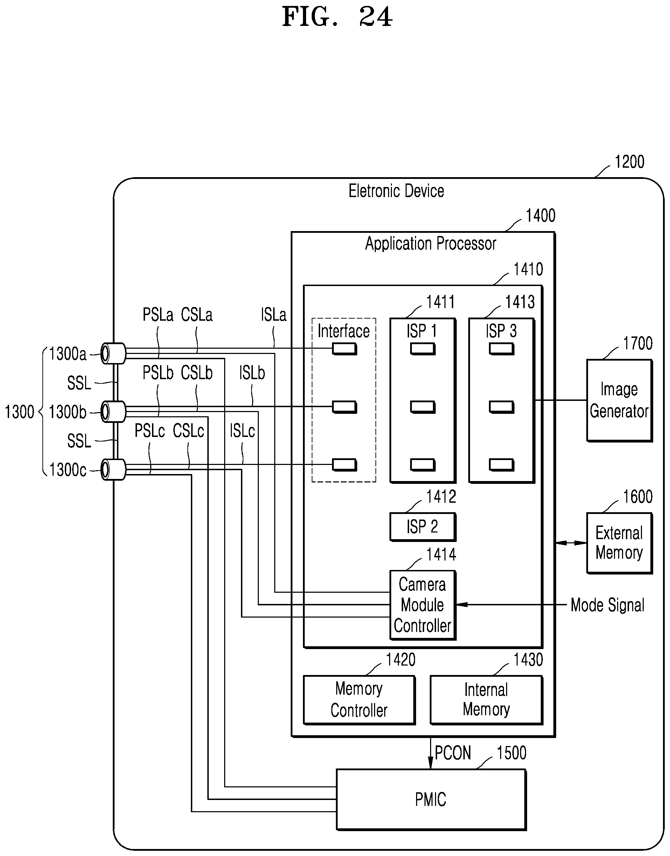

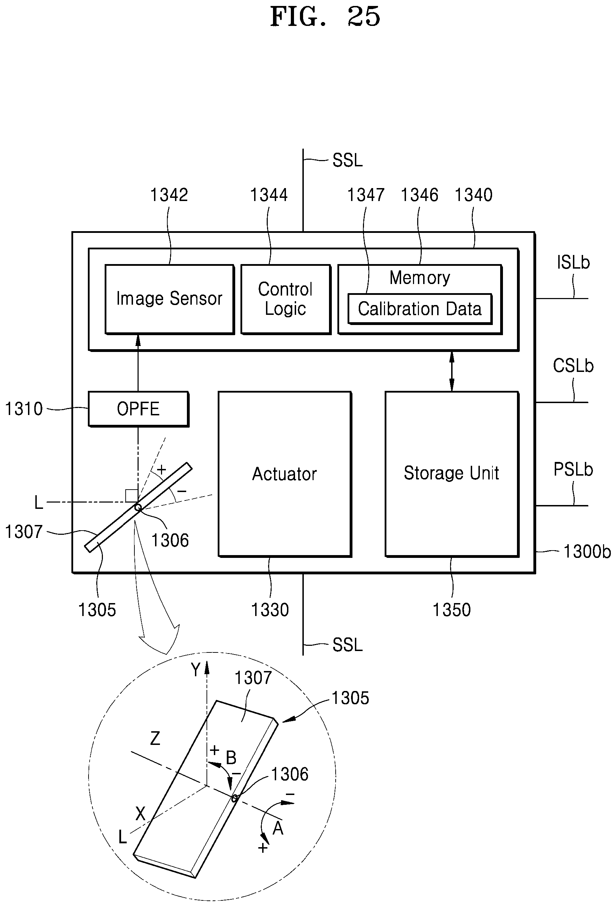

FIG. 24 is a block diagram of an electronic device 1200 including a multi-camera module, and FIG. 25 is a detailed block diagram of the camera module in the electronic device shown in FIG. 24.

Referring to FIG. 24, the electronic device 1200 may include a camera module group 1300, an application processor 1400, a power management integrated circuit (PMIC) 1500, an external memory 1600, and an image generator 1700.

The camera module group 1300 may include a plurality of camera modules 1300a, 1300b, and 1300c. Although the drawings show an example in which three camera modules 1300a, 1300b, and 1300c are arranged, one or more embodiments are not limited thereto. In some embodiments, the camera module group 1300 may be modified to include only two camera modules. Also, in some embodiments, the camera module group 1300 may be modified to include n (n is 4 or greater natural number) camera modules.

Hereinafter, detailed configuration of one camera module 1300b is described as an example below with reference to FIG. 25, but the description provided below may be also applied to the other camera modules 1300a and 1300c according to the example embodiments.

Referring to FIG. 25, the camera module 1300b may include a prism 1305, an optical path folding element (OPFE) 1310, an actuator 1330, an image sensing device 1340, and a storage unit 1350.

The prism 1305 may include a reflecting surface 1307 having a light-reflecting material and may deform a path of light L incident from outside.

In some example embodiments, the prism 1305 may change the path of the light L incident in the first direction (X-direction) into a second direction (Y-direction) that is perpendicular to the first direction (X-direction). Also, the prism 1305 may rotate the reflecting surface 1307 having the light-reflecting material about a center axis 1306 in a direction A, or about the center axis 1306 in a direction B such that the path of the light L incident in the first direction (X-direction) may be changed to the second direction (Y-direction) perpendicular to the first direction (X-direction). Here, the OPFE 1310 may also move in the third direction (Z-direction) that is perpendicular to the first direction (X-direction) and the second direction (Y-direction).

In some example embodiments, as shown in the drawings, the maximum rotation angle of the prism 1305 in the direction A is 15° or less in the positive A direction and is greater than 15° in the negative A direction, but embodiments are not limited thereto.

In some example embodiments, the prism 1305 may be moved by the angle of about 20°, or between 10° to 20° or 15° to 20° in the positive or negative B direction. Here, the moving angle is the same in the positive or negative B direction, or may be similar within a range of about 1°.

In some example embodiments, the prism 1305 may move the reflecting surface 1307 of the light-reflective material in the third direction (e.g., Z direction) that is parallel to the direction in which the center axis 1306 extends.

The OPFE 1310 may include, for example, optical lenses formed as m groups (here, m is a natural number). Here, m lenses move in the second direction (Y-direction) and may change an optical zoom ratio of the camera module 1300b. For example, when a basic optical zoom ratio of the camera module 1300b is Z and m optical lenses included in the OPFE 1310 move, the optical zoom ratio of the camera module 1300b may be changed to 3Z, 5Z, or 10Z or greater.

The actuator 1330 may move the OPFE 1310 (hereinafter, referred to as optical lens) to a certain position. For example, the actuator 1330 may adjust the position of the optical lens such that the image sensor 1342 may be located at a focal length of the optical lens for exact sensing operation.

An image sensing device 1340 may include the image sensor 1342, a control logic 1344, and a memory 1346. The image sensor 1342 may sense an image of a sensing target by using the light L provided through the optical lens. The control logic 1344 may control the overall operation of the camera module 1300b. For example, the control logic 1344 may control the operations of the camera module 1300b according to a control signal provided through a control signal line CSLb.

For example, the image sensor 1342 may include the color separating lens array or the nano-photonic lens array described above. The image sensor 1342 may receive more signals separated according to wavelengths in each pixel by using the color separating lens array based on the nano-structures. Due to the above effects, the optical intensity required to generate high quality images of high resolution and under the low illuminance may be secured.

The memory 1346 may store information that is necessary for the operation of the camera module 1300b, e.g., calibration data 1347. The calibration data 1347 may include information that is necessary to generate image data by using the light L provided from outside through the camera module 1300b. The calibration data 1347 may include, for example, information about the degree of rotation described above, information about the focal length, information about an optical axis, etc. When the camera module 1300b is implemented in the form of a multi-state camera of which the focal length is changed according to the position of the optical lens, the calibration data 1347 may include information related to focal length values of the optical lens according to each position (or state) and auto-focusing.

The storage unit 1350 may store image data sensed through the image sensor 1342. The storage unit 1350 may be disposed out of the image sensing device 1340 and may be stacked with a sensor chip included in the image sensing device 1340. In some example embodiments, the storage unit 1350 may be implemented as electrically erasable programmable read-only memory (EEPROM), but one or more embodiments are not limited thereto.

Referring to FIGS. 24 and 25, in some example embodiments, each of the plurality of camera modules 1300a, 1300b, and 1300c may include the actuator 1330. Accordingly, each of the plurality of camera modules 1300a, 1300b, and 1300c may include the calibration data 1347 that is the same as or different from the others, according to the operation of the actuator 1330 included therein.

In some example embodiments, one (for example, 1300b) of the plurality of camera modules 1300a, 1300b, and 1300c may be a camera module in a folded lens type including the prism 1305 and the OPFE 1310 described above, and the other camera modules (for example, 1300a and 1300c) may be vertical type camera modules not including the prism 1305 and the OPFE 1310. However, the disclosure is not limited thereto.

In some example embodiments, one (for example, 1300c) of the plurality of camera modules 1300a, 1300b, and 1300c may be a depth camera of a vertical type, which extracts depth information by using infrared ray (IR).

In some example embodiments, at least two camera modules (e.g., 1300a and 1300b) from among the plurality of camera module 1300a, 1300b, and 1300c may have different fields of view. In this case, for example, the optical lenses of the at least two camera modules (e.g., 1300a and 1300b) from among the plurality of camera modules 1300a, 1300b, and 1300c may be different from each other, but one or more embodiments are not limited thereto.

Also, in some example embodiments, the plurality of camera modules 1300a, 1300b, and 1300c may have different fields of view from one another. In this case, the optical lenses respectively included in the plurality of camera modules 1300a, 1300b, and 1300c may be different from one another, but the inventive concept is not limited thereto.

In some example embodiments, the plurality of camera modules 1300a, 1300b, and 1300c may be physically isolated from one another. That is, the sensing region of one image sensor 1342 may not be divided and used by the plurality of camera modules 1300a, 1300b, and 1300c, but the plurality of camera modules 1300a, 1300b, and 1300c may each have an independent image sensor 1342 provided therein.

Referring back to FIG. 24, the application processor 1400 may include an image processing device 1410, a memory controller 1420, and an internal memory 1430. The application processor 1400 may be separately implemented from the plurality of camera modules 1300a, 1300b, and 1300c. For example, the application processor 1400 and the plurality of camera modules 1300a, 1300b, and 1300c may be separately implemented as separate semiconductor chips.

The image processing device 1410 may include a plurality of image processors 1411, 1412, and 1413, and a camera module controller 1414.

The image data generated by each of the camera modules 1300a, 1300b, and 1300c may be provided to the image processing device 1410 via separate image signal lines ISLa, ISLb, and ISLc, respectively. The image data transfer may be carried out by using a camera serial interface (CSI) based on a mobile industry processor interface (MIPI), for example, but is not limited thereto.

The image data transferred to the image processing device 1410 may be stored in an external memory 1600 before being transferred to the image processors 1411 and 1412. The image data stored in the external memory 1600 may be provided to the image processor 1411 and/or the image processor 1412. The image processor 1411 may correct the image data in order to generate video. The image processor 1412 may correct the image data in order to generate still images. For example, the image processors 1411 and 1412 may perform a pre-processing operation such as a color calibration, a gamma calibration on the image data.

The image processor 1411 may include sub-processors. When the number of sub-processors is equal to the number of camera modules 1300a, 1300b, and 1300c, each of the sub-processors may process the image data provided from one camera module. When the number of sub-processors is less than the number of camera modules 1300a, 1300b, and 1300c, at least one of the sub-processors may process the image data provided from a plurality of camera module by using a timing-sharing process. The image data processed by the image processor 1411 and/or the image processor 1412 may be stored in the external memory 1600 before being transferred to the image processor 1413. The image data stored in the external memory 1600 may be transferred to the image processor 1413. The image processor 1413 may perform a post-processing operation such as a noise calibration, a sharpen calibration, etc. on the image data.

The image data processed in the image processor 1413 may be provided to the image generator 1700. The image generator 1700 may generate a final image by using the image data provided from the image processor 1413 according to image generating information or a mode signal.

For example, the image generator 1700 may generate the output image by merging at least parts of the image data generated by the camera modules 1300a, 1300b, and 1300c having different fields of view, according to image generating information or the mode signal. Also, the image generator 1700 may generate the output image by selecting one of pieces of image data generated by the camera modules 1300a, 1300b, and 1300c having different fields of view, according to image generating information or the mode signal.

In some example embodiments, the image generating information may include a zoom signal or a zoom factor. Also, in some example embodiments, the mode signal may be, for example, a signal based on a mode selected by a user.

When the image generating information is a zoom signal (zoom factor) and the camera modules 1300a, 1300b, and 1300c have different fields of view (angles of view) from one another, the image generator 1700 may perform different operations according to the kind of zoom signal. For example, when the zoom signal is a first signal, the image data output from the camera module 1300a is merged with the image data output from the camera module 1300c, and then, the output image may be generated by using the merged image signal and the image data output from the camera module 1300b and not used in the merge. When the zoom signal is a second signal that is different from the first signal, the image generator 1700 may not perform the image data merging, and then, may generate the output image by selecting one piece of the image data output respectively from the camera modules 1300a, 1300b, and 1300c. However, one or more embodiments are not limited thereto, and the method of processing the image data may be modified as necessary.

The camera module controller 1414 may provide each of the camera modules 1300a, 1300b, and 1300c with a control signal. The control signals generated by the camera module controller 1414 may be provided to corresponding camera modules 1300a, 1300b, and 1300c via control signal lines CSLa, CSLb, and CSLc separated from one another.

In some example embodiments, the control signal provided to the plurality of camera modules 1300a, 1300b, and 1300c from the camera module controller 1414 may include mode information according to the mode signal. The plurality of camera modules 1300a, 1300b, and 1300c may operate in a first operation mode and a second operation mode in relation to the sensing speed, based on the mode information.

In the first operation mode, the plurality of camera modules 1300a, 1300b, and 1300c may generate the image signal at a first speed (for example, generating an image signal of a first frame rate), encodes the image signal at a second speed that is faster than the first speed (for example, encoding the image signal of a second frame rate that is greater than the first frame rate), and transfers the encoded image signal to the application processor 1400. Here, the second speed may be 30 times faster than the first speed or less.

The application processor 1400 may store the received image signal, that is, the encoded mage signal, in the internal memory 1430 provided therein or the external memory 1600 outside the application processor 1400, and after that, reads and decodes the encoded signal from the internal memory 1430 or the external memory 1600, and may display the image data generated based on the decoded image signal. For example, the image processors 1411 and 1412 in the image processing device 1410 may perform decoding, and may perform image processing on the decoded image signals.

In the second operation mode, the plurality of camera modules 1300a, 1300b, and 1300c generates an image signal at a third speed that is slower than the first speed (for example, generating the image signal of a third frame rate that is lower than the first frame rate), and may transfer the image signal to the application processor 1400. The image signal provided to the application processor 1400 may be a signal that is not encoded. The application processor 1400 may perform the image processing of the received image signal or store the image signal in the internal memory 1430 or the external memory 1600.

The PMIC 1500 may supply the power, for example, the power voltage, to each of the plurality of camera modules 1300a, 1300b, and 1300c. For example, the PMIC 1500 may supply the first power to the camera module 1300a via a power signal line PSLa, the second power to the camera module 1300b via a power signal line PSLb, and the third power to the camera module 1300c via a power signal line PSLc, under the control of the application processor 1400.

The PMIC 1500 may generate the power corresponding to each of the plurality of camera modules 1300a, 1300b, and 1300c and may adjust the power level, in response to a power control signal PCON from the application processor 1400. The power control signal PCON may include a power adjusting signal for each operation mode of the plurality of camera modules 1300a, 1300b, and 1300c. For example, the operation mode may include a low power mode, and the power control signal PCON may include information about the camera module operating in the low-power mode and set power level. The levels of the power provided to the plurality of camera modules 1300a, 1300b, and 1300c may be equal to or different from each other. Also, the power level may be dynamically changed.

It should be understood that example embodiments described herein should be considered in a descriptive sense only and not for purposes of limitation. Descriptions of features or aspects within each example embodiment should typically be considered as available for other similar features or aspects in other embodiments. While example embodiments have been described with reference to the figures, it will be understood by those of ordinary skill in the art that various changes in form and details may be made therein without departing from the scope as defined by the following claims.

## Claims

1. An image sensor comprising:

   a sensor substrate (110) comprising a first pixel (111), a second pixel (112), a third pixel (113) and a fourth pixel (114), the first pixel, the second pixel, the third pixel, and the fourth pixel being configured to sense light; and
   a nano-photonic lens array (140) comprising a first meta-region (141), a second meta-region (142), a third meta-region (143) and a fourth meta-region (144), the first meta-region corresponding to the first pixel, the second meta-region corresponding to the second pixel, the third meta-region corresponding to the third pixel, and the fourth meta-region corresponding to the fourth pixel,
   wherein each of the first meta-region, the second meta-region, the third meta-region, and the fourth meta-region comprises a plurality of nano-structures (NP) configured to color-separate incident light that is incident on the nano-photonic lens array and condense light of a first wavelength band onto the first pixel and the fourth pixel, light of a second wavelength band onto the second pixel, and light of a third wavelength band onto the third pixel,
   **characterised in that**, , in a plan view, the first meta-region comprises a plurality of pairs of two nano-structures that are symmetrical in a first direction at different distances in a second direction that is perpendicular to the first direction from a horizontal center line (Lx), the horizontal center line passing through a center of the first meta-region along the first direction, and
   wherein, in a direction toward the horizontal center line in the second direction, an interval between two symmetrical nano-structures among the plurality of pairs of two nano-structures in the first direction increases, and in a direction away from the horizontal center line in the second direction, an interval between two symmetrical nano-structures among the plurality of pairs of two nano-structures in the first direction decreases.

2. The image sensor of claim 1, wherein an interval in the first direction between two nano-structures among the plurality of pairs of two nano-structures that are symmetrical on the horizontal center line in the first direction is L/8 to 3L/8, where L is a length of a side of the first meta-region.

3. The image sensor of claim 2, wherein an interval ΔS in the first direction between two symmetrical nano-structures that are arranged at a distance d from the horizontal center line in the second direction satisfies:

$$2L(0.13-0.47y^2)<\Delta S<2L(0.38-0.96y^2-0.89y^4-1.63y^6),$$

where y=d/L and 0 < y < 0.5.

4. The image sensor of any preceding claim, wherein the first meta-region comprises:

a first nano-structure on a vertical center line that passes through the center of the first meta-region in the second direction;
a second nano-structure and a third nano-structure that are symmetrical in the first direction at a first distance from the horizontal center line in the second direction; and
a fourth nano-structure and a fifth nano-structure that are symmetrical in the first direction at a second distance from the horizontal center line in the second direction, the second distance being less than the first distance, wherein an interval between the fourth nano-structure and the fifth nano-structure in the first direction is greater than an interval between the second nano-structure and the third nano-structure in the first direction, and optionally wherein the second nano-structure and the third nano-structure are symmetrical to each other in the first direction with respect to the vertical center line, and the fourth nano-structure and the fifth nano-structure are symmetrical to each other in the first direction with respect to the vertical center line.

5. The image sensor of claim 4, wherein an interval in the first direction between the fourth nano-structure and the fifth nano-structure or an interval in the first direction between the second nano-structure and the third nano-structure, which are at a distance d from the horizontal center line in the second direction, is ΔS, and ΔS satisfies:

$$2L(0.13-0.47y^2)<\Delta S<2L(0.38-0.96y^2-0.89y^4-1.63y^6),$$

where L denotes a length of one side of the first meta-region, and y=d/L and 0 < y < 0.5.

6. The image sensor of claim 4 or 5, wherein the first nano-structure has a first cross-sectional size, the second nano-structure and the third nano-structure have a second cross-sectional size, and the fourth nano-structure and the fifth nano-structure have a third cross-sectional size, and wherein an average of the second cross-sectional size and the third cross-sectional size is greater than the first cross-sectional size, and optionally wherein a ratio of the first cross-sectional size with respect to the average of the second cross-sectional size and the third cross-sectional size is less than or equal to 0.85, and further optionally wherein a ratio of the first cross-sectional size with respect to the average of the second cross-sectional size and the third cross-sectional size is 0.7 to 0.8.

7. The image sensor of any of claims 4 to 6, wherein the first meta-region comprises:

a sixth nano-structure and a seventh nano-structure that are symmetrical in the first direction at the first distance from the horizontal center line in the second direction; and
an eighth nano-structure and a ninth nano-structure that are symmetrical in the first direction at the second distance from the horizontal center line in the second direction, wherein an interval between the second nano-structure and the third nano-structure in the first direction is greater than an interval between the sixth nano-structure and the seventh nano-structure in the first direction, and wherein an interval between the fourth nano-structure and the fifth nano-structure in the first direction is greater than an interval between the eighth nano-structure and the ninth nano-structure in the first direction.

8. The image sensor of any of claims 4 to 7, wherein the fourth nano-structure is on a first diagonal line passing through the center of the first meta-region, and the fifth nano-structure is on a second diagonal line that crosses the first diagonal line and passes through the center of the first meta-region, and optionally wherein the first meta-region further comprises a plurality of nano-structures that are respectively symmetrical to the second nano-structure and the third nano-structure with respect to the first diagonal line, and a plurality of nano-structures that are respectively symmetrical to the second nano-structure and the third nano-structure with respect to the second diagonal line, and further optionally wherein: the first nano-structure, the second nano-structure, the third nano-structure, the fourth nano-structure, and the fifth nano-structure have a cross-sectional size of greater than 80 nm; and
the plurality of nano-structures that are respectively symmetrical to the second nano-structure and the third nano-structure with respect to the first diagonal line and the plurality of nano-structures that are respectively symmetrical to the second nano-structure and the third nano-structure with respect to the second diagonal line each have a cross-sectional size less than or equal to 80 nm.

9. The image sensor of any of claims 4 to 8, wherein the first meta-region further comprises a plurality of nano-structures that are symmetrical to the first nano-structure, the second nano-structure, the third nano-structure, the fourth nano-structure, and the fifth nano-structure in the second direction with respect to the horizontal center line.

10. The image sensor of any preceding claim, wherein the first meta-region comprises:

a first-1 nano-structure and a first-2 nano-structure that are symmetrical in the first direction;
a second nano-structure and a third nano-structure that are symmetrical in the first direction at a first distance from the horizontal center line in the second direction; and
a fourth nano-structure and a fifth nano-structure that are symmetrical in the first direction at a second distance from the horizontal center line in the second direction, the second distance being less than the first distance, wherein an interval between the fourth nano-structure and the fifth nano-structure in the first direction is greater than an interval between the second nano-structure and the third nano-structure in the first direction, and wherein an interval between the first-1 nano-structure and the first-2 nano-structure in the first direction is less than an interval between the second nano-structure and the third nano-structure in the first direction.

11. The image sensor of claim 10, wherein an average cross-sectional size of the first-1 nano-structure and the first-2 nano-structure is less than an average cross-sectional size of the second nano-structure, the third nano-structure, the fourth nano-structure, and the fifth nano-structure.

12. The image sensor of claim 10 or 11, wherein a ratio of an average cross-sectional size of the first-1 nano-structure and the first-2 nano-structure with respect to an average cross-sectional size of the second to fifth nano-structures is less than or equal to 0.85.

13. The image sensor of any of claims 10 to 12, wherein the first-1 nano-structure and the first-2 nano-structure are between a pair of the second nano-structure and the third nano-structure and a pair of the fourth nano-structure and the fifth nano-structure in the second direction from the horizontal center line.

14. The image sensor of any preceding claim, wherein the first meta-region and the fourth meta-region are arranged in a first diagonal direction, and the second meta-region and the third meta-region are arranged in a second diagonal direction that crosses the first diagonal direction, and
wherein the fourth meta-region is rotated by a 90-degree angle with respect to the first meta-region.

15. An electronic apparatus comprising:

a lens assembly configured to form an optical image of a subject;
an image sensor according to any preceding claim configured to convert the optical image formed by the lens assembly into an electrical signal; and
a processor configured to process the electrical signal generated by the image sensor.

**Patentansprüche**

1. Bildsensor, umfassend:

ein Sensorsubstrat (110), das ein erstes Pixel (111), ein zweites Pixel (112), ein drittes Pixel (113) und ein viertes Pixel (114) umfasst, wobei das erste Pixel, das zweite Pixel, das dritte Pixel und das vierte Pixel dazu konfiguriert sind, Licht zu erfassen; und

eine nanophotonische Linsenanordnung (140), die eine erste Meta-Region (141), eine zweite Meta-Region (142), eine dritte Meta-Region (143) und eine vierte Meta-Region (144) umfasst, wobei die erste Meta-Region dem ersten Pixel entspricht, die zweite Meta-Region dem zweiten Pixel entspricht, die dritte Meta-Region dem dritten Pixel entspricht und die vierte Meta-Region dem vierten Pixel entspricht,

wobei jede von der ersten Meta-Region, der zweiten Meta-Region, der dritten Meta-Region und der vierten Meta-Region eine Vielzahl von Nanostrukturen (NP) umfasst, die dazu konfiguriert sind, einfallendes Licht, das auf die nanophotonische Linsenanordnung einfällt, farblich zu trennen und Licht eines ersten Wellenlängenbandes auf das erste Pixel und das vierte Pixel, Licht eines zweiten Wellenlängenbandes auf das zweite Pixel und Licht eines dritten Wellenlängenbandes auf das dritte Pixel zu kondensieren,

**dadurch gekennzeichnet, dass** in einer Draufsicht die erste Meta-Region eine Vielzahl von Paaren von zwei Nanostrukturen umfasst, die symmetrisch in einer ersten Richtung in unterschiedlichen Abständen in einer zweiten Richtung sind, die senkrecht zu der ersten Richtung von einer horizontalen Mittellinie (Lx) ist, wobei die horizontale Mittellinie durch eine Mitte der ersten Meta-Region entlang der ersten Richtung verläuft, und

wobei in einer Richtung zu der horizontalen Mittellinie in der zweiten Richtung ein Intervall zwischen zwei symmetrischen Nanostrukturen unter der Vielzahl von Paaren von zwei Nanostrukturen in der ersten Richtung zunimmt und in einer Richtung weg von der horizontalen Mittellinie in der zweiten Richtung ein Intervall zwischen zwei symmetrischen Nanostrukturen unter der Vielzahl von Paaren von zwei Nanostrukturen in der ersten Richtung abnimmt.

2. Bildsensor nach Anspruch 1, wobei ein Intervall in der ersten Richtung zwischen zwei Nanostrukturen unter der Vielzahl von Paaren von zwei Nanostrukturen, die symmetrisch auf der horizontalen Mittellinie in der ersten Richtung sind, L/8 bis 3L/8 ist, wobei L eine Länge einer Seite der ersten Meta-Region ist.

3. Bildsensor nach Anspruch 2, wobei ein Intervall $\Delta S$ in der ersten Richtung zwischen zwei symmetrischen Nanostrukturen, die in einem Abstand d von der horizontalen Mittellinie in der zweiten Richtung angeordnet sind, Folgendes erfüllt:

$$2L(0,13\text{-}0,47y^2)<\Delta S<2L(0,38\text{-}0,96y^2\text{-}0,89y^4\text{-}1,63y^6),$$

wobei y=d/L und 0 < y < 0,5.

4. Bildsensor nach einem vorhergehenden Anspruch, wobei die erste Meta-Region Folgendes umfasst:

eine erste Nanostruktur auf einer vertikalen Mittellinie, die durch die Mitte der ersten Meta-Region in der zweiten Richtung verläuft;
eine zweite Nanostruktur und eine dritte Nanostruktur, die symmetrisch in der ersten Richtung in einem ersten Abstand von der horizontalen Mittellinie in der zweiten Richtung sind; und
eine vierte Nanostruktur und eine fünfte Nanostruktur, die symmetrisch in der ersten Richtung in einem zweiten Abstand von der horizontalen Mittellinie in der zweiten Richtung sind, wobei der zweite Abstand weniger als der erste Abstand ist,
wobei ein Intervall zwischen der vierten Nanostruktur und der fünften Nanostruktur in der ersten Richtung größer als ein Intervall zwischen der zweiten Nanostruktur und der dritten Nanostruktur in der ersten Richtung ist und wobei optional die zweite Nanostruktur und die dritte Nanostruktur symmetrisch zueinander in der ersten Richtung in Bezug auf die vertikale Mittellinie sind und die vierte Nanostruktur und die fünfte Nanostruktur symmetrisch zueinander in der ersten Richtung in Bezug auf die vertikale Mittellinie sind.

5. Bildsensor nach Anspruch 4, wobei ein Intervall in der ersten Richtung zwischen der vierten Nanostruktur und der fünften Nanostruktur oder ein Intervall in der ersten Richtung zwischen der zweiten Nanostruktur und der dritten Nanostruktur, die in einem Abstand d von der horizontalen Mittellinie in der zweiten Richtung sind, $\Delta S$ ist und $\Delta S$ Folgendes erfüllt:

$$2L(0,13\text{-}0,47y^2)<\Delta S<2L(0,38\text{-}0,96y^2\text{-}0,89y^4\text{-}1,63y^6),$$

wobei L eine Länge einer Seite der ersten Meta-Region bezeichnet und y=d/L und 0 < y < 0,5.

6. Bildsensor nach Anspruch 4 oder 5, wobei die erste Nanostruktur eine erste Querschnittsgröße aufweist, die zweite Nanostruktur und die dritte Nanostruktur eine zweite Querschnittsgröße aufweisen und die vierte Nanostruktur und die fünfte Nanostruktur eine dritte Querschnittsgröße aufweisen, und

wobei ein Durchschnitt der zweiten Querschnittsgröße und der dritten Querschnittsgröße größer als die erste Querschnittsgröße ist und wobei optional ein Verhältnis der ersten Querschnittsgröße in Bezug auf den Durchschnitt der zweiten Querschnittsgröße und der dritten Querschnittsgröße weniger als oder gleich 0,85 ist und wobei ferner optional ein Verhältnis der ersten Querschnittsgröße in Bezug auf den Durchschnitt der zweiten Querschnittsgröße und der dritten Querschnittsgröße 0,7 bis 0,8 ist.

7. Bildsensor nach einem der Ansprüche 4 bis 6, wobei die erste Meta-Region Folgendes umfasst:

eine sechste Nanostruktur und eine siebte Nanostruktur, die symmetrisch in der ersten Richtung in dem ersten Abstand von der horizontalen Mittellinie in der zweiten Richtung sind; und
eine achte Nanostruktur und eine neunte Nanostruktur, die symmetrisch in der ersten Richtung in dem zweiten Abstand von der horizontalen Mittellinie in der zweiten Richtung sind,
wobei ein Intervall zwischen der zweiten Nanostruktur und der dritten Nanostruktur in der ersten Richtung größer als ein Intervall zwischen der sechsten Nanostruktur und der siebten Nanostruktur in der ersten Richtung ist, und
wobei ein Intervall zwischen der vierten Nanostruktur und der fünften Nanostruktur in der ersten Richtung größer als ein Intervall zwischen der achten Nanostruktur und der neunten Nanostruktur in der ersten Richtung ist.

8. Bildsensor nach einem der Ansprüche 4 bis 7, wobei die vierte Nanostruktur auf einer ersten Diagonallinie ist, die durch die Mitte der ersten Meta-Region verläuft, und die fünfte Nanostruktur auf einer zweiten Diagonallinie ist, welche die erste Diagonallinie kreuzt und durch die Mitte der ersten Meta-Region verläuft, und wobei optional die erste Meta-Region ferner eine Vielzahl von Nanostrukturen, die jeweils symmetrisch zu der zweiten Nanostruktur und der dritten Nanostruktur in Bezug auf die erste Diagonallinie sind, und eine Vielzahl von Nanostrukturen, die jeweils symmetrisch zu der zweiten Nanostruktur und der dritten Nanostruktur in Bezug auf die zweite Diagonallinie sind, umfasst, und wobei ferner optional: die erste Nanostruktur, die zweite Nanostruktur, die dritte Nanostruktur, die vierte Nanostruktur und die fünfte Nanostruktur eine Querschnittsgröße von mehr als 80 nm aufweisen; und die Vielzahl von Nanostrukturen, die jeweils symmetrisch zu der zweiten Nanostruktur und der dritten Nanostruktur in Bezug auf die erste Diagonallinie sind, und die Vielzahl von Nanostrukturen, die jeweils symmetrisch zu der zweiten Nanostruktur und der dritten Nanostruktur in Bezug auf die zweite Diagonallinie sind, jeweils eine Querschnittsgröße von weniger als oder gleich 80 nm aufweisen.

9. Bildsensor nach einem der Ansprüche 4 bis 8, wobei die erste Meta-Region ferner eine Vielzahl von Nanostrukturen umfasst, die symmetrisch zu der ersten Nanostruktur, der zweiten Nanostruktur, der dritten Nanostruktur, der vierten Nanostruktur und der fünften Nanostruktur in der zweiten Richtung in Bezug auf die horizontale Mittellinie sind.

10. Bildsensor nach einem vorhergehenden Anspruch, wobei die erste Meta-Region Folgendes umfasst:

eine erste-1 Nanostruktur und eine erste-2 Nanostruktur, die symmetrisch in der ersten Richtung sind;
eine zweite Nanostruktur und eine dritte Nanostruktur, die symmetrisch in der ersten Richtung in einem ersten Abstand von der horizontalen Mittellinie in der zweiten Richtung sind; und
eine vierte Nanostruktur und eine fünfte Nanostruktur, die symmetrisch in der ersten Richtung in einem zweiten Abstand von der horizontalen Mittellinie in der zweiten Richtung sind, wobei der zweite Abstand weniger als der erste Abstand ist,
wobei ein Intervall zwischen der vierten Nanostruktur und der fünften Nanostruktur in der ersten Richtung größer als ein Intervall zwischen der zweiten Nanostruktur und der dritten Nanostruktur in der ersten Richtung ist, und
wobei ein Intervall zwischen der ersten-1 Nanostruktur und der ersten-2 Nanostruktur in der ersten Richtung weniger als ein Intervall zwischen der zweiten Nanostruktur und der dritten Nanostruktur in der ersten Richtung ist.

11. Bildsensor nach Anspruch 10, wobei eine durchschnittliche Querschnittsgröße der ersten-1 Nanostruktur und der ersten-2 Nanostruktur weniger als eine durchschnittliche Querschnittsgröße der zweiten Nanostruktur, der dritten Nanostruktur, der vierten Nanostruktur und der fünften Nanostruktur ist.

12. Bildsensor nach Anspruch 10 oder 11, wobei ein Verhältnis einer durchschnittlichen Querschnittsgröße der ersten-1 Nanostruktur und der ersten-2 Nanostruktur in Bezug auf eine durchschnittliche Querschnittsgröße der zweiten bis fünften Nanostruktur weniger als oder gleich 0,85 ist.

**13.** Bildsensor nach einem der Ansprüche 10 bis 12, wobei die erste-1-Nanostruktur und die erste-2-Nanostruktur zwischen einem Paar der zweiten Nanostruktur und der dritten Nanostruktur und einem Paar der vierten Nanostruktur und der fünften Nanostruktur in der zweiten Richtung von der horizontalen Mittellinie sind.

**14.** Bildsensor nach einem vorhergehenden Anspruch, wobei die erste Meta-Region und die vierte Meta-Region in einer ersten Diagonalrichtung angeordnet sind und die zweite Meta-Region und die dritte Meta-Region in einer zweiten Diagonalrichtung angeordnet sind, welche die erste Diagonalrichtung kreuzt, und
wobei die vierte Meta-Region um einen 90-Grad-Winkel in Bezug auf die erste Meta-Region gedreht ist.

**15.** Elektronische Vorrichtung, umfassend:

eine Linsenbaugruppe, die dazu konfiguriert ist, ein optisches Bild eines Subjekts zu bilden;
einen Bildsensor nach einem vorhergehenden Anspruch, der dazu konfiguriert ist, das optische Bild, das durch die Linsenbaugruppe gebildet wird, in ein elektrisches Signal umzuwandeln; und
einen Prozessor, der dazu konfiguriert ist, das elektrische Signal zu verarbeiten, das durch den Bildsensor erzeugt wird.

**Revendications**

**1.** Capteur d'image comprenant :

un substrat de capteur (110) comprenant un premier pixel (111), un deuxième pixel (112), un troisième pixel (113) et un quatrième pixel (114),
le premier pixel, le deuxième pixel, le troisième pixel et le quatrième pixel étant configurés pour détecter la lumière ; et
un réseau de lentilles nano-photoniques (140) comprenant une première métarégion (141), une deuxième métarégion (142), une troisième métarégion (143) et une quatrième métarégion (144),
la première métarégion correspondant au premier pixel, la deuxième métarégion correspondant au deuxième pixel, la troisième métarégion correspondant au troisième pixel, et la quatrième métarégion correspondant au quatrième pixel,
dans lequel chacune de la première métarégion, de la deuxième métarégion, de la troisième métarégion et de la quatrième métarégion comprend une pluralité de nanostructures (NP) configurées pour séparer en couleur la lumière incidente qui est incidente sur le réseau de lentilles nano-photoniques et condenser la lumière d'une première bande de longueur d'onde sur le premier pixel et le quatrième pixel, la lumière d'une deuxième bande de longueur d'onde sur le deuxième pixel et la lumière d'une troisième bande de longueur d'onde sur le troisième pixel,
**caractérisé en ce que**, en vue en plan, la première métarégion comprend une pluralité de paires de deux nanostructures qui sont symétriques dans une première direction à différentes distances dans une seconde direction qui est perpendiculaire à la première direction à partir d'une ligne centrale horizontale (Lx), la ligne centrale horizontale passant par un centre de la première métarégion le long de la première direction, et
dans lequel, dans une direction vers la ligne centrale horizontale dans la seconde direction, un intervalle entre deux nanostructures symétriques parmi la pluralité de paires de deux nanostructures dans la première direction augmente, et dans une direction s'éloignant de la ligne centrale horizontale dans la seconde direction, un intervalle entre deux nanostructures symétriques parmi la pluralité de paires de deux nanostructures dans la première direction diminue.

**2.** Capteur d'image selon la revendication 1, dans lequel un intervalle dans la première direction entre deux nano-structures parmi la pluralité de paires de deux nanostructures qui sont symétriques sur la ligne centrale horizontale dans la première direction est L/8 à 3L/8, où L est une longueur d'un côté de la première métarégion.

**3.** Capteur d'image selon la revendication 2, dans lequel un intervalle $\Delta S$ dans la première direction entre deux nanostructures symétriques qui sont agencées à une distance d de la ligne centrale horizontale dans la seconde direction satisfait :

$$2L(0,13 - 0,47y^2)<\Delta S<2L(0,38 - 0,96\,y^2 - 0,89y^4 - 1,63y^6),$$

où y=d/L et 0 < y < 0,5.

4. Capteur d'image selon l'une quelconque revendication précédente, dans lequel la première métarégion comprend :

une première nanostructure sur une ligne centrale verticale qui passe par le centre de la première métarégion dans la seconde direction ;
une deuxième nanostructure et une troisième nanostructure qui sont symétriques dans la première direction à une première distance de la ligne centrale horizontale dans la seconde direction ; et
une quatrième nanostructure et une cinquième nanostructure qui sont symétriques dans la première direction à une deuxième distance de la ligne centrale horizontale dans la seconde direction, la deuxième distance étant inférieure à la première distance,
dans lequel un intervalle entre la quatrième nanostructure et la cinquième nanostructure dans la première direction est supérieur à un intervalle entre la deuxième nanostructure et la troisième nanostructure dans la première direction, et éventuellement dans lequel la deuxième nanostructure et la troisième nanostructure sont symétriques l'une par rapport à l'autre dans la première direction par rapport à la ligne centrale verticale, et la quatrième nanostructure et la cinquième nanostructure sont symétriques l'une par rapport à l'autre dans la première direction par rapport à la ligne centrale verticale.

5. Capteur d'image selon la revendication 4, dans lequel un intervalle dans la première direction entre la quatrième nanostructure et la cinquième nanostructure ou un intervalle dans la première direction entre la deuxième nanostructure et la troisième nanostructure, qui sont à une distance d de la ligne centrale horizontale dans la seconde direction, est $\Delta S$, et $\Delta S$ satisfait :

$$2L(0,13 - 0,47y^2) < \Delta S < 2L(0,38 - 0,96y^2 - 0,89y^4 - 1,63y^6),$$

où L désigne une longueur d'un côté de la première métarégion, et y=d/L et 0 < y < 0,5.

6. Capteur d'image selon la revendication 4 ou 5, dans lequel la première nanostructure a une première taille de section transversale, la deuxième nanostructure et la troisième nanostructure ont une deuxième taille de section transversale, et la quatrième nanostructure et la cinquième nanostructure ont une troisième taille de section transversale, et
dans lequel une moyenne de la deuxième taille de section transversale et de la troisième taille de section transversale est supérieure à la première taille de section transversale, et éventuellement dans lequel un rapport de la première taille de section transversale par rapport à la moyenne de la deuxième taille de section transversale et de la troisième taille de section transversale est inférieur ou égal à 0,85, et en outre éventuellement dans lequel un rapport de la première taille de section transversale par rapport à la moyenne de la deuxième taille de section transversale et de la troisième taille de section transversale est de 0,7 à 0,8.

7. Capteur d'image selon l'une quelconque des revendications 4 à 6, dans lequel la première métarégion comprend :

une sixième nanostructure et une septième nanostructure qui sont symétriques dans la première direction à la première distance de la ligne centrale horizontale dans la seconde direction ; et
une huitième nanostructure et une neuvième nanostructure qui sont symétriques dans la première direction à la deuxième distance de la ligne centrale horizontale dans la seconde direction,
dans lequel un intervalle entre la deuxième nanostructure et la troisième nanostructure dans la première direction est supérieur à un intervalle entre la sixième nanostructure et la septième nanostructure dans la première direction, et
dans lequel un intervalle entre la quatrième nanostructure et la cinquième nanostructure dans la première direction est supérieur à un intervalle entre la huitième nanostructure et la neuvième nanostructure dans la première direction.

8. Capteur d'image selon l'une quelconque des revendications 4 à 7, dans lequel la quatrième nanostructure se trouve sur une première ligne diagonale passant par le centre de la première métarégion, et la cinquième nanostructure se trouve sur une deuxième ligne diagonale qui croise la première ligne diagonale et passe par le centre de la première métarégion, et éventuellement dans lequel la première métarégion comprend en outre une pluralité de nanostructures qui sont respectivement symétriques à la deuxième nanostructure et à la troisième nanostructure par rapport à la première ligne diagonale, et une pluralité de nanostructures qui sont respectivement symétriques à la deuxième nanostructure et à la troisième nanostructure par rapport à la deuxième ligne diagonale, et en outre éventuellement dans lequel : la première nanostructure, la deuxième nanostructure, la troisième nanostructure, la quatrième nanostructure et la cinquième nanostructure ont une taille de section transversale supérieure à 80 nm ; et la pluralité de nanostructures qui sont respectivement symétriques à la deuxième nanostructure et à la troisième nanostructure par rapport à la première ligne diagonale et la pluralité de nanostructures qui sont respectivement symétriques à la deuxième nanostructure et à la troisième nanostructure par rapport à la deuxième ligne diagonale ont chacune une taille de section transversale inférieure ou égale à 80 nm.

9. Capteur d'image selon l'une quelconque des revendications 4 à 8, dans lequel la première métarégion comprend en outre une pluralité de nanostructures qui sont symétriques à la première nanostructure, à la deuxième nanostructure, à la troisième nanostructure, à la quatrième nanostructure, et à la cinquième nanostructure dans la seconde direction par rapport à la ligne centrale horizontale.

10. Capteur d'image selon l'une quelconque revendication précédente, dans lequel la première métarégion comprend :

une première-1 nanostructure et une première-2 nanostructure qui sont symétriques dans la première direction ; une deuxième nanostructure et une troisième nanostructure qui sont symétriques dans la première direction à une première distance de la ligne centrale horizontale dans la seconde direction ; et une quatrième nanostructure et une cinquième nanostructure qui sont symétriques dans la première direction à une deuxième distance de la ligne centrale horizontale dans la seconde direction, la deuxième distance étant inférieure à la première distance, dans lequel un intervalle entre la quatrième nanostructure et la cinquième nanostructure dans la première direction est supérieur à un intervalle entre la deuxième nanostructure et la troisième nanostructure dans la première direction, et dans lequel un intervalle entre la première-1 nanostructure et la première-2 nanostructure dans la première direction est inférieur à un intervalle entre la deuxième nanostructure et la troisième nanostructure dans la première direction.

11. Capteur d'image selon la revendication 10, dans lequel une taille de section transversale moyenne de la première-1 nanostructure et de la première-2 nanostructure est inférieure à une taille de section transversale moyenne de la deuxième nanostructure, de la troisième nanostructure, de la quatrième nanostructure et de la cinquième nano-structure.

12. Capteur d'image selon la revendication 10 ou 11, dans lequel un rapport d'une taille de section transversale moyenne de la première-1 nanostructure et de la première-2 nanostructure par rapport à une taille de section transversale moyenne des deuxième à cinquième nanostructures est inférieur ou égal à 0,85.

13. Capteur d'image selon l'une quelconque des revendications 10 à 12, dans lequel la première-1 nanostructure et la première-2 nanostructure sont entre une paire de la deuxième nanostructure et de la troisième nanostructure et une paire de la quatrième nanostructure et de la cinquième nanostructure dans la seconde direction à partir de la ligne centrale horizontale.

14. Capteur d'image selon l'une quelconque des revendications précédentes, dans lequel la première métarégion et la quatrième métarégion sont agencées dans une première direction diagonale, et la deuxième métarégion et la troisième métarégion sont agencées dans une seconde direction diagonale qui croise la première direction diagonale, et dans lequel la quatrième métarégion est tournée à un angle de 90 degrés par rapport à la première métarégion.

15. Appareil électronique comprenant :

un ensemble lentille configuré pour former une image optique d'un sujet ; un capteur d'image selon l'une quelconque revendication précédente configuré pour convertir l'image optique formée par l'ensemble lentille en un signal électrique ; et un processeur configuré pour traiter le signal électrique généré par le capteur d'image.

# FIG. 1

# FIG. 2A

# FIG. 2B

1100

| Y | B | Y | B | Y | B | Y | B |
|---|---|---|---|---|---|---|---|
| R | Y | R | Y | R | Y | R | Y |
| Y | B | Y | B | Y | B | Y | B |
| R | Y | R | Y | R | Y | R | Y |
| Y | B | Y | B | Y | B | Y | B |
| R | Y | R | Y | R | Y | R | Y |

Y
Z · → X

# FIG. 2C

1100

| Y | C | Y | C | Y | C | Y | C |
|---|---|---|---|---|---|---|---|
| M | Y | M | Y | M | Y | M | Y |
| Y | C | Y | C | Y | C | Y | C |
| M | Y | M | Y | M | Y | M | Y |
| Y | C | Y | C | Y | C | Y | C |
| M | Y | M | Y | M | Y | M | Y |

Y
Z · → X

# FIG. 3A

# FIG. 3B

# FIG. 4A

110

| 111 | 112 | 111 | 112 | 111 | 112 | 111 | 112 |
|-----|-----|-----|-----|-----|-----|-----|-----|
| 113 | 114 | 113 | 114 | 113 | 114 | 113 | 114 |
| 111 | 112 | 111 | 112 | 111 | 112 | 111 | 112 |
| 113 | 114 | 113 | 114 | 113 | 114 | 113 | 114 |
| 111 | 112 | 111 | 112 | 111 | 112 | 111 | 112 |
| 113 | 114 | 113 | 114 | 113 | 114 | 113 | 114 |
| 111 | 112 | 111 | 112 | 111 | 112 | 111 | 112 |
| 113 | 114 | 113 | 114 | 113 | 114 | 113 | 114 |

Y

Z X

# FIG. 4B

# FIG. 5

EP 4 561 303 B1

FIG. 6

37

# FIG. 7

# FIG. 8

## FIG. 9

140

GL

| 141 | 142 | 141 | 142 |
| 143 | 144 | 143 | 144 |
| 141 | 142 | 141 | 142 |
| 143 | 144 | 143 | 144 |

Y

Z X

## FIG. 10

140

| 141 | 142 | 141 | 142 |
| 143 | 144 | 143 | 144 |
| 141 | 142 | 141 | 142 |
| 143 | 144 | 143 | 144 |

BL

Y

Z X

# FIG. 11

140

RL

| 141 | 142 | 141 | 142 |
| 143 | 144 | 143 | 144 |
| 141 | 142 | 141 | 142 |
| 143 | 144 | 143 | 144 |

Y
Z X

# FIG. 12

AF_score (%)

r = 0.85

CD ratio : w1 / avg (w2, w3)

# FIG. 13

# FIG. 14

FIG. 15

FIG. 16

# FIG. 17

# FIG. 18

# FIG. 19

# FIG. 20

# FIG. 21

# FIG. 22

# FIG. 23

ED80

1120
FLASH

1110
LENS
ASSEMBLY

1000
IMAGE SENSOR

1140
IMAGE
STABILIZER

1150
MEMORY

1160
IMAGE SIGNAL
PROCESSOR

# FIG. 24

# FIG. 25

**REFERENCES CITED IN THE DESCRIPTION**

**Patent documents cited in the description**

- US 2023020980 A1
- US 2023115006 A1